# EUROPÄISCHE PATENTSCHRIFT

(11) **EP 0 393 434 B1**
(45) Veröffentlichungstag und Bekanntmachung des Hinweises auf die Patenterteilung: **03.01.1996**
(21) Anmeldenummer: 90106587.0
(22) Anmeldetag: 06.04.1990
(51) Int. Cl.: G11C 5/02

(54) **Statischer Speicher**
Static memory
Mémoire statique

(30) Priorität: 21.04.1989 DE 3913209
(43) Veröffentlichungstag der Anmeldung: 24.10.1990
(73) Patentinhaber: SIEMENS AKTIENGESELLSCHAFT, D-80333 München (DE)
(72) Erfinder: Mattausch, Hans-Jürgen, Dr. rer. nat., D-8011 Brunnthal-Faistenhaar (DE); Hoppe, Bernhard, Dr. rer. nat. (bei Dr.W. Krüger), D-6000 Frankfurt 1 (DE); Neuendorf, Gerd, Dipl.-Ing., D-8034 Germering (DE); Schmitt-Landsiedel, Doris, Dr. rer. nat., D-8012 Ottobrunn (DE); Pfleiderer, Hans-Jörg, Prof. Dr.-Ing., D-8011 Zorneding (DE); Wurm, Maria, D-8012 Ottobrunn (DE)

(56) Entgegenhaltungen:
- EP-A- 0 393 435
- WO-A-87/00339
- MEAD CARVER A ET AL 'Introduction to VLSI Systems' Oktober 1980 , ADDISON- WESLEY , READING US
- IEEE JOURNAL OF SOLID-STATE CIRCUITS. Bd. 23, Nr. 5, Oktober 1988, NEW YORK US Seiten 1060 - 1066; KOHNO ET AL: 'A 14-ns 1-Mbit CMOS SRAM with Variable Bit Organization'
- IBM TECHNICAL DISCLOSURE BULLETIN. Bd. 31, Nr. 1, Juni 1988, NEW YORK US Seite 291; 'Combined single/dual-port array approach with 6-device cell'
- ELECTRONICS AND COMMUNICATIONS IN JAPAN. Bd. 63, Nr. 9, September 1980, NEW YORK US Seiten 81 - 90; FUKUDA ET AL: '256-bit Elastic Store CMOS LSI'
- MAVOR J ET AL 'Introduction to MOS LSI Design' 1983 , ADDISON-WESLEY , LONDON
- WESTE NEIL H E ET AL 'Principles of CMOS VLSI Design - A Systems Perspective' Oktober 1985 , ADDISON-WESLEY , READING US
- IEEE JOURNAL OF SOLID-STATE CIRCUITS. Bd. 19, Nr. 5, Oktober 1984, NEW YORK US Seiten 578 - 585; SAKURAI ET AL: 'A Low Power 46ns 256kbit CMOS Static RAM with Dynamic Double Word Line'
- PROCEEDINGS IEEE COMPEURO 89 - VLSI AND COMPUTER PERIPHERALS 8. Mai 1989, WASHINGTON US SCHMITT-LANDSIEDEL ET AL: 'Hierarchical Architecture for Fast CMOS SRAMs'

## Beschreibung

Die Erfindung betrifft einen aus Speicherzellen hierarchisch aufgebauten Speicher nach dem Oberbegriff des Patentanspruches 1.

Wie aus dem Bericht ISSCC Digest of Technical Papers 1988, Session 13: "Statics RAMs" hervorgeht, werden schnelle statische Speicher in CMOS-Technologie üblicherweise mit vier oder sechs Transistorzellen und höchstens zwei Hierarchieebenen realisiert. Eine höhere Geschwindigkeit wird zumeist durch eine Verbesserung der Technologie hinsichtlich der Strukturfeinheit, der Mehrlagenverdrahtung und spezieller Prozeßoptionen wie "buried contact" oder Hochohm-Polysilizium erreicht.

Innerhalb eines gegebenen Prozesses können jedoch auch durch schaltungstechnische Maßnahmen Geschwindigkeitsvorteile erzielt werden. Hierzu wurde bereits vorgeschlagen, durch die Einführung mehrerer Hierarchiestufen die Zugriffszeit zu verkürzen, da die Verzögerungszeiten auf langen Wort- und Datenleitungen vermieden werden. In der Veröffentlichung von C. Mead, L. Conway, "Introduction to VLSI-Systems", Second Edition, Addison-Wesley, 1980, Kapitel 8.5, auf die sich des Oberbegriff des Anspruchs 1 stützt, wird hierfür allerdings eine dynamische Eintransistorspeicherzelle betrachtet. In der Figur 8.31 der genannten Veröffentlichung ist eine in zwei Hierarchieebenen aufgeteilter Speicher angegeben, der jedoch keine detaillierten Angaben zur Ausführung peripherer Schaltungen wie Dekoder und Leseverstärker enthält. Der Aufbau der ersten Hierarchiestufe für einen 16-Zellblock ist in der genannten Veröffentlichung in Figur 8.32 wiedergegeben. Der ermöglichte Geschwindigkeitsvorteil durch den hierarchischen Aufbau wird erkauft mit einem erhöhten Bedarf durch die Vervielfachung der Ansteuer- und Leseschaltungen, insbesondere auf der ersten Hierarchiestufe.

Aus der Veröffentlichung IEEE Journal of Solid-State Circuits, Vol. 23, Nr. 5, Okt. 1988, Seiten 1060 bis 1066 ist eine Realisierungsmöglichkeit von in Spalten- und Zeilenschaltungen vorzusehenden Schaltungsteilen bekannt. Ferner ist hieraus bekannt, daß der Speicher mit statischen Speicherzellen (SRAM) aufgebaut ist.

Aus der Veröffentlichung Electronics And Communications in Japan, Vol. 63, No. 9, Sept. 1980, Seiten 81 bis 90 sind Realisierungsmöglichkeiten für entsprechende Speicherzellen bekannt.

Ferner sind aus der Veröffentlichung Weste Neil H E et al., 'Prinicpes of CMOS VLSI Design - A System Perspective', Okt. 1985, Seiten 160 bis 163, Realisierungsmöglichkeiten von NAND- und NOR-Gattern in den Spalten- und Zeilenschaltungen bekannt.

Der Erfindung liegt die Aufgabe zugrunde, einen hierarchisch aufgebauten Speicher mit kurzer Zugriffszeit anzugeben, der geringe Abmessungen zum Aufbau erfordert.

Diese Aufgabe wird erfindungsgemäß durch die im kennzeichnenden Teil des Patentanspruches 1 angegebenen Merkmale gelöst.

Die mit der Erfindung erzielten Vorteile bestehen insbesondere darin, daß der Aufbau in mehreren Hierarchiestufen auch für statische Speicher anwendbar ist. Auch hier ist der Flächenaufwand für die Ansteuer- und Ausleseschaltungen in der ersten Hierarchieebene besonders kritisch. Vorteilhaft sind daher Speicherzellen, die ein starkes Zellsignal liefern, so daß wenig Aufwand in der Leseschaltung nötig ist. Ein weiterer Vorteil der Erfindung besteht darin, daß Peripherieschaltungen in den Spalten- und Zeilenschaltungen die flächenaufwendige Schaltungsteile erfordern wie Dekoder und Datenmultiplexer möglichst in den oberen Hierarchieebenen ausgeführt werden.

Die Patentansprüche 2 bis 17 sind auf eine bevorzugte Ausgestaltung des Speichers gerichtet, die dort näher erläutert wird.

Die Erfindung wird nachfolgend anhand von Zeichnungen näher beschrieben, es zeigen dabei:
- Figur 1: den Aufbau eines hierarchischen RAMs nach dem Stand der Technik in drei Hierarchieebenen,
- Figur 2: Blockschaltbild eines beispielhaften statischen 64 K-Speichers mit hierarchischer Architektur,
- Figur 3: die Anordnung von Speicherzellen mit einer Schreib- und einer Lesewortleitung innerhalb der zweiten Hierarchieebene,
- Figur 4: Anordnung von Speicherzellen nach Figur 3 unter Verwendung komprimierter Mehrfunktionsgatter,
- Figur 5: Anordnung von Speicherzellen mit zwei in Serie geschalteten Auswahltransistoren und drei Wortleitungen, innerhalb der zweiten Hierarchieebene,
- Figur 6: Anordnung von Speicherzellen mit zwei in Serie geschalteten Auswahltransistoren und zwei Wortleitungen, innerhalb der zweiten Hierarchieebene.

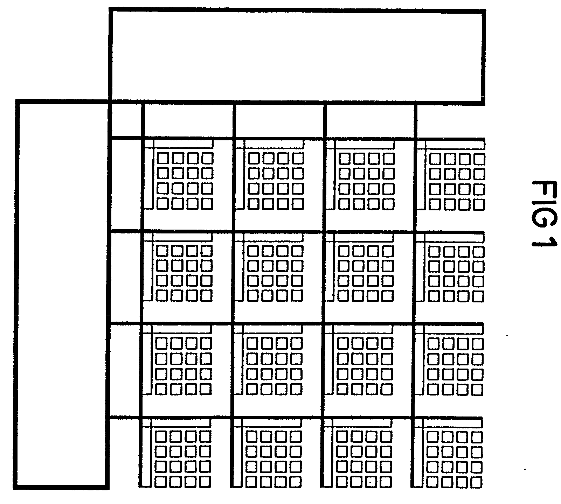

Figur 1 zeigt den Stand der Technik aus der Veröffentlichung von C. Mead, L. Conway "Introduction to VLSI-Systems", Second Edition, Edison-Wesly, 1980, Kapitel 8,5. Hierin wird der Aufbau eines hierarchischen Speichers (RAM) auf drei Hierarchieebenen beschrieben. Eine erste Hierarchieebene wird aus einer einzelnen Speicherzelle gebildet, während eine Speichergruppe aus 4 x 4 Speicherzellen die zweite Hierarchieebene darstellen. Auf der dritten Hierarchieebene schließlich werden 4 x 4 Speichergruppen zusammengefaßt und durch eine Zeilen- und Spaltenschaltung jeweils angesteuert. Wie weiter aus Figur 1 zu erkennen ist enthält auch jede Speichergruppe eine zugehörige Zeilen- und Spaltenleitung, die zum Aktivieren der jeweiligen Speicherzelle in der Speichergruppe dient. In dieser Veröffentlichung wird allerdings eine dynamische Eintransistorspeicherzelle betrachtet und es werden keinerlei detaillierten Angaben zur Ausführung und zur Verdrahtung von peripheren Schaltungen wie Dekoder und Leseverstärker angegeben.

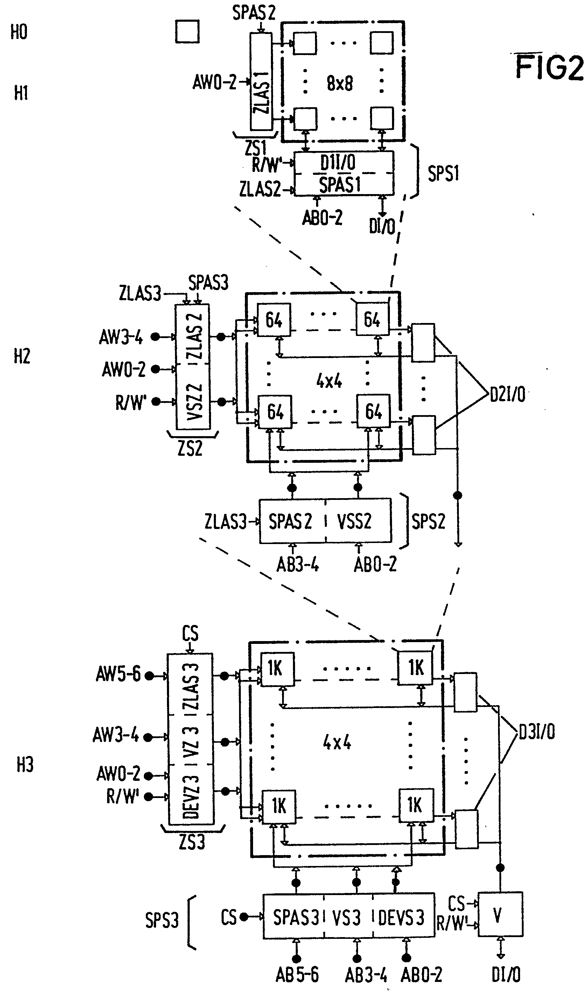

Figur 2 zeigt das Blockschaltbild eines beispielhaften statischen 16 K-Speichers mit hierarchischer Architektur. In diesem Beispiel wird der Speicher in vier Hierarchieebenen aufgebaut. Die niedrigste Hierarchieebene HO wird durch eine einzelne Speicherzelle gebildet, während auf der Hierarchieebene H1 8 x 8 Speicherzellen zu einer Speichergruppe zusammengefaßt werden. In der Hierarchieebene H2 sind 4 x 4 Speichergruppen zusammengefaßt, wobei jede einzelne Speichergruppe 64 Speicherzellen enthält. In der Hierarchieebene H3 schließlich sind 4 x 4 Blöcke angeordnet, wobei jeder einzelne dieser Blöcke eine Speicherkapazität von 1 K-Bit besitzt und entsprechend der 4 x 4 Speichergruppen auf Hierarchieebene H2 aufgebaut ist. Um eine schnelle Zugriffszeit bei guter Raumausnutzung zu gewährleisten wurde die Aufteilung des Speichers in vier Hierarchieebenen gewählt. Die Zugriffszeit könnte auch noch verbessert werden durch den Einsatz von kleineren Unterblöcken, beispielsweise von Speichergruppen mit der Größe 4 x 4 Speicherzellen auf der Hierarchieebene H1.

Für einen hierarchisch organisierten statischen Speicher muß ein neues Dekodierschema entwickelt werden. Um eine möglichst geringe Leistungsaufnahme des statischen Speichers zu erzielen und um die Verzögerungszeit zu verringern, die sich aufgrund eines hohen "Fan-out" der Multiplexer und Dekodierschaltungen auf der jeweiligen Hierarchieebene ergeben, ist es nicht vorteilhaft die Dateneingänge und die niedrigen Adreßleitungen an alle Speichergruppen auf einer Hierarchieebene zu aktivieren. Statt dessen ist es vorteilhaft, die Signale auf diesen Leitungen auf höheren Hierarchieebenen vorzuselektieren. Dies wird mit Hilfe von Blockselektsignalen ermöglicht, die von den höherwertigen Adreßbits erzeugt werden. Hierdurch werden die vorselektierten Adreß- und Datensignale nur zu den vorausgewählten Unterblöcken weitergeleitet. Würden jedoch alle Signale auf den Daten und niedrigen Adreßleitungen auf jeder Hierarchieebene selektiert, so würde dies aufgrund der benötigten Gatteranordnungen in dem Dekodierpfad eine zu hohe Verzögerungszeit verursachen. Um dies zu vermeiden werden Teile der Dekodierung in parallel arbeitende Blöcke aufgeteilt.

Demzufolge sind auf der Hierarchieebene H1 allen Spalten von 8 x 8 Speicherzellen eine Datenein- und -ausgangsschaltung D1I/O zugeordnet, während auf der Hierarchieebene H2 je eine Datenein-und -ausgangsschaltung D2I/O pro Zeile der 64 Speicherzellen Elemente vorhanden sind. Ebenso ist auf der Hierarchieebene H3 einer Zeile von 1 K Speicherblöcken jeweils eine Datenein- und -ausgangsschaltung D3I/O zugeordnet. Die Datenleitungen der dritten Hierarchieebene H3 werden auf einen Verstärker und Zwischenspeicher V geschaltet, der ein gezieltes Datenein- und -auslesen für den statischen Speicher ermöglicht. Hierzu wird der Verstärker und Zwischenspeicher mit einem Chipselektsignal CS und einem Schreib/Lesesignal R/W' angesteuert. Wie aus der Figur 2 ersichtlich ist in der Hierarchiestufe H1, H2 und H3 je eine Zeilen- und Spaltenschaltung ZS1, ZS2, ZS3 bzw. SPS1, SPS2, SPS3 vorhanden, die jedoch auf jeder Hierarchiestufe unterschiedlich ausgebildet sind. Auf der Hierarchiestufe H3 enthält eine Spaltenschaltung SPS3 eine Spaltenauswahlschaltung SPAS3 für die höchstwertigen Adreßbits der Bitleitungen AB5 und AB6, einen Verstärker und Zwischenspeicher VS3 für die Adreßbits der Bitleitungen AB3 bis AB4 und ein Dekodier-und Vorselektionseinrichtung DEVS3 für die niedrigstwertigsten Adreßbits der Bitleitungen AB0 bis AB2. Ebenso enthält die Zeilenschaltung ZS3 auf dieser Hierarchieebene eine dreifache Aufteilung bestehend aus einer Dekodier- und Vorselekteinrichtung für die niedrigstwertigsten Adreßbits der Wortleitungen AW0 bis AW2 und des angelegten Schreiblesesignals R/W', einen Verstärker und Zwischenspeicher VZ3 für die Adreßbits der Wortleitungen AW3 und AW4 und eine Zeilenauswahlschaltung ZLAS3 für die höchstwertigen Adreßbits der Wortleitungen AW5 und AW6. Sowohl die Zeilen- ZS3 als auch die Spaltenschaltung SPS3 auf dieser Hierarchieebene werden jeweils mit Chipselektsignalen CS angesteuert. Die Dekodiereinrichtung in der Zeilen- und Spaltenschaltung DEVZ3, DEVS3 auf der Hierarchieebene H3 dekodiert bereits die niedrigstwertigsten Adreßbits AB0 bis AB2 bzw. AW0 bis AW2, die erst auf der ersten Hierarchieebene H1 benötigt werden. Um diese niedrigstwertigsten Adreßbits nicht auf alle der 1 K-Blöcke zu schalten werden diese mit Hilfe der höchstwertigen Adreßbits AB5 bis AB6 bzw.AW5 bis AW6 vorselektiert und nur einer Zeile bzw. einer Spalte von 1 K-Blöcken aufgeschaltet. Dies wird ermöglicht durch intern generierte Blockselektsignale in der Zeilen- und Speicherschaltung ZS3, SPS3. Auf der Hierarchieebene H2 enthält die Spaltenschaltung SPS2 eine Vorselektionseinrichtung VSS2, der die dekodierten niedrigstwertigsten Adreßbits der Bitleitung AB0 bis AB2 zugeführt sind und eine Spaltenauswahlschaltung SPAS2, an die die Adreßbits der Bitleitungen AB3 bis AB4 angeschlossen sind. Weiterhin benötigt werden für die Spaltenschaltung SPS2 das Zeilenauswahlsignal aus der Zeilenauswahlschaltung ZLAS 3 der Hierarchieebene H3. Auch die Zeilenschaltung ZS2 der Hierarchieebene H2 enthält eine Zweifachaufteilung bestehend aus einer Vorselektionseinrichtung VSZ2, der die dekodierten niedrigstwertigsten Adreßbits der Wortleitung AW0 bis AW2 und das vorselektierte Schreiblesesignal R/W' zugeführt werden und eine Zeilenauswahlschaltung ZLAS2, an die die Adressen der Wortleitungen AW3 und AW4 anzuschließen sind. Angesteuert wird die Zeilenschaltung ZS2 auf der Hierarchieebene H2 aus dem Spaltenauswahlsignal der Spaltenauswahlschaltung SPAS3 und dem Zeilenauswahlsignal der Zeilenauswahlschaltung ZLAS3 jeweils aus der vierten Hierarchieebene H3. Auch auf der Hierarchieebene H2 werden die niedrigstwertigsten dekodierten Adreßbits AB0 bis AB2 bzw. AW0 bis AW2 vorselektiert und nur an eine Spalte bzw. Zeile von Speichergruppen aus 64 Speicherzellen aufgeschaltet. Dies wird wieder mit Hilfe von intern gebildeten Blockselektsignalen erreicht, die aus den Adressen der Bitleitungen AB3 und AB4 bzw. AW3 bis AW4 generiert werden. In der zweiten Hierarchieebene H1 schließlich ist in der Spaltenschaltung SPS1 eine Datenein- und Ausgangs schaltung D1I/0 sowie eine Spaltenauswahlschaltung SPAS1 enthalten. Die Datenein- und Ausgangsschaltung D1I/0 steuert den bidirektionalen Datenverkehr zwischen den einzelnen Speicherzellen der Speichergruppe. Der Spaltenschaltung SPS1 sind daher die dekodierten niedrigstwertigsten Adreßbits der Bitleitungen AB0 bis AB2 und die Datenein- und Ausgangsleitungen DI/0 aufgeschaltet. Zur Ansteuerung dienen hierbei ein vorselektiertes Schreib/Lesesignal R/W' für die Datenein-ausgangsschaltung D1I/0 und ein Zeilenauswahlsignal welches in der Zeilenauswahlschaltung ZLAS2 innerhalb der dritten Hierarchieebene H2 gebildet wird. Die Zeilenauswahlschaltung ZS1 der Speichergruppen in der Hierarchieebene H1 enthält lediglich eine Zeilenauswahlschaltung ZLAS1, der dekodierte niedrigstwertigste Adreßbits der Wortleitungen AW0 bis AW2 zugeführt werden und die durch ein Spaltenauswahlsignal gesteuert wird. Hierbei wird das Spaltenauswahlsignal wiederum aus der Spaltenauswahlschaltung SPAS2 der nächst höheren Hierarchieebene H2 entnommen.

Im folgenden wird nun eine Realisierung der ersten Hierarchieebene unter Verwendung von dafür besonders geeigneten neuartigen Speicherzellen vorgeschlagen, die in der Patentanmeldung EP-A-0 393 435 "Statische Speicherzelle" in verschiedenen Varianten beschrieben wurden. Speicherzellen mit getrennten Schreib- und Lesewortleitungen, sowie getrennten Schreib- und Lesedatenleitungen eignen sich besonders gut für den Einsatz in einem statischen Speicher mit mehreren Hierarchiestufen. Wegen der kurzen Wort- und Datenleitungen können Speicherzellen der genannten Patentanmeldung EP-A-0 393 435 hier wie ein Register in einer logischen Schaltung betrachtet werden. Da statt der üblichen Differenzsignale auf einem Datenleitungspaar nur ein Datensignal mit dem vollen CMOS-Pegel erzielt wird, kann als Ausleseschaltung ein Inverter verwendet werden, der viel platzsparender ist als ein sonst üblicher Differenzverstärker. Noch kompakter wird die Ausleseschaltung, wenn anstelle des Inverters ein logisches Gatter eingesetzt wird, in dem eine Stufe der im Auslesepfad erforderlich Datenzusammenführung gleich mit durchgeführt wird. Durch die getrennte Ausführung von Schreib- und Lesewortleitungen ist es zudem nicht nötig, die Dateneingangs- und Datenausgangssignale innerhalb der ersten Hierarchieebene mit der Schreib-Lesesteuerung zu verknüpfen. Dadurch kann Fläche und Signallaufzeit eingespart werden.

Für die verschiedenen Zellvarianten aus der obengenannten Patentanmeldung ergeben sich unterschiedliche Vorschläge für die Ausführung der Schaltungen der ersten Hierarchieebene. Sie sind im folgenden für einen Zellblock aus 16 Zellen beschrieben. Das gezeigte Konzept ist auch für andere Zellblockgrößen anwendbar, entsprechend einem anderen Faktor f, wobei hier f = 4 gewählt wurde, oder für Anordnungen mit unterschiedlicher Anzahl von Zeilen und Spalten. Dabei erscheint insbesondere eine Version mit mehr Zeilen als Spalten günstig, zum Beispiel ein 8 x 16 Zellblock, da im allgemeinen bei quadratischen Zellblöcken die Verzögerungszeit auf der Wortleitung größer ist als auf der Datenleitung.

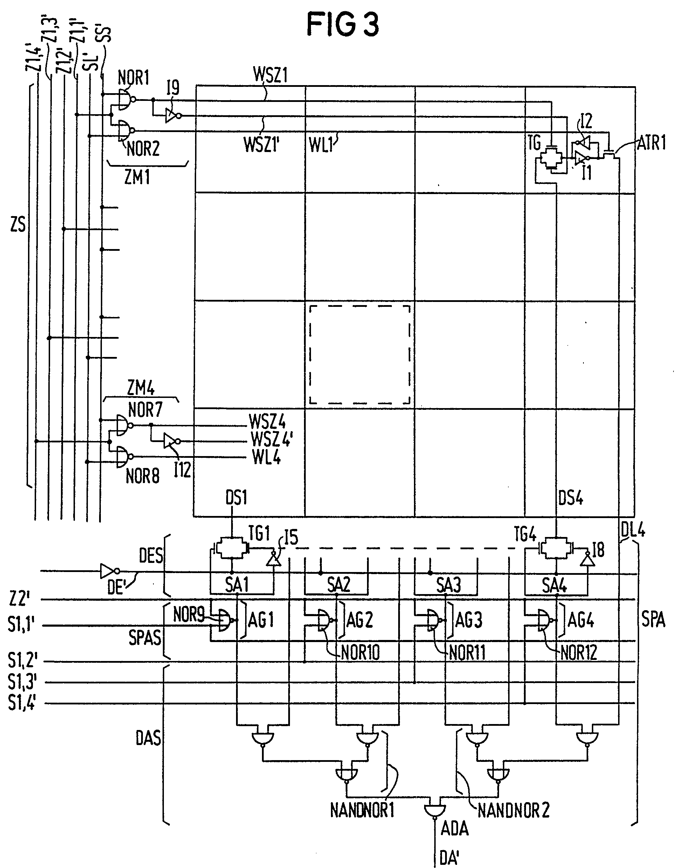

Figur 3 zeigt die Anordnung von Speicherzellen mit einer Schreib- (DS1...DS4) und einer Lesewortleitung (DL1...DL4) in einem Block aus 16 Speicherzellen eines hierarchisch aufgebauten statischen Speichers mit einem NAND-Gatter in der Datenausleseschaltung. Die Leitungen zur Auswahl einer Spalte S1, i und einer Zeile Z1, i, i = 1...4 der Zellblöcke werden auf einer höheren Hierarchieebene dekodiert um in der zweiten Hierarchieebene Fläche und Verzögerungszeft einzusparen. In der in Figur 2 gezeigten Ausführung erfolgt die 1:4 Dekodierung der entsprechenden Wort- und Bitadressen AW0, AW1 sowie AB0, AB1 in der vierten Hierarchieebene H3. In der dritten Hierarchieebene H2 werden die vordekodierten Signale mit Auswahlsignalen verknüpft, damit nur die benötigten Unterblöcke aktiviert werden. Durch eine geringere Belastung der betreffenden Treiberschaltungen wird Verlustleistung und Zeit hierbei eingespart. Die Signale zur Auswahl einer Spalte von Zellblöcken zum Schreiben mit Hilfe der Leitung SS' oder Lesen mit Hilfe der Leitung SL', sowie zur Auswahl einer Zeile von Zellblöcken durch die Leitung Z2' werden in der dritten Hierarchieebene H2 durch Verknüpfung von übergeordneten Signalen der Zeilen- und Spaltendekodierung erzeugt.

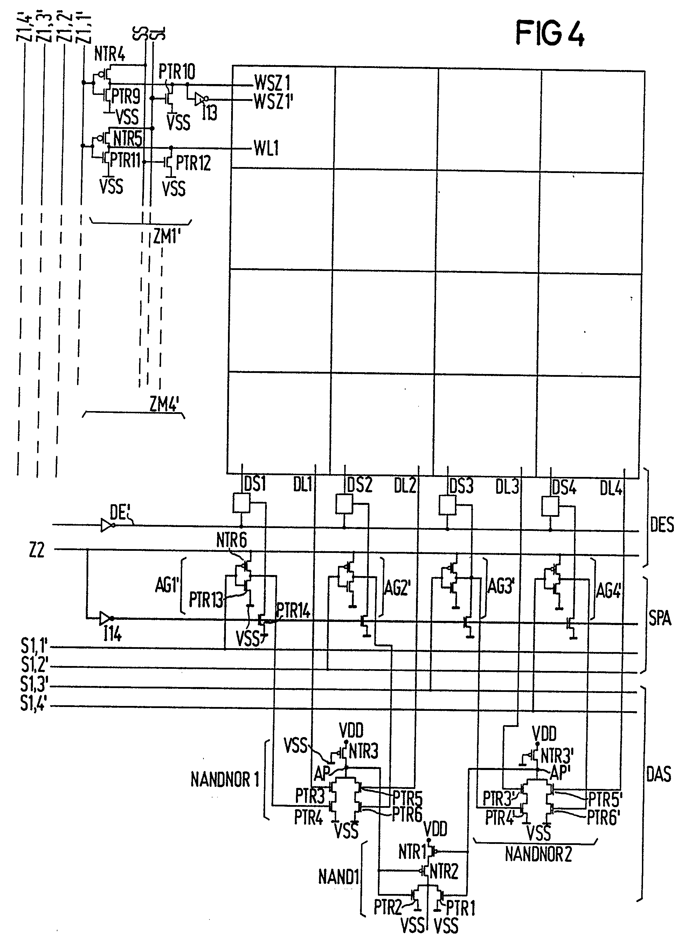

Figur 3 zeigt ein Speicherfeld aus 4 x 4 Speicherzellen. Jede Speicherzelle enthält ein Transfergatter TG, zwei Inverter I1, I2 und einen Auswahltransistor ATR1. Das Transfergatter TG der Speicherzelle ist hierbei zwischen der zu der Spalte der Speicherzelle zugehörigen Datenleitung zum Einlesen von Informationen DS4 und einem Eingang des ersten Inverters I1 geschaltet, wobei der zweite Inverter I2 auf den ersten Inverter I1 rückgekoppelt ist. Der Auswahltransistor ATR1 der jeweiligen Speicherzelle ist zwischen einem Ausgang des ersten Inverters I1 und der zu der Spalte der Speicherzelle zugehörigen Datenleitung zum Auslesen von Informationen DL4 geschaltet. Für eine ausführliche Beschreibung dieses Typs von Speicherzellen sei auf die Figur 4 und den zugehörigen Beschreibungsteil in der Patentanmmeldung EP-A-0 393 435 mit der Bezeichnung "Statische Speicherzelle" verwiesen.

Das Speicherzellenfeld in Figur 3 ist in vier Spalten und vier Zeilen von Speicherzellen aufgeteilt. Jeder Spalte läßt sich hierbei eine Datenleitung zum Einlesen von Informationen DS1... DS4 und eine Datenleitung zum Auslesen von Informationen DL1 ...DL4 zuordnen, während jeder Zeile zwei Wortleitungen zum Einlesen von Informationen WSZ1, WSZ1'...WSZ4, WSZ4' und eine Wortleitung zum Auslesen von Informationen WL1...WL4 erfordern. Die zu einer Spalte zugehörigen Datenleitung zum Einlesen (DS1...DS4) wird hierbei an jedes Transfergatter der Speicherzelle gelegt, die sich innerhalb der Spalte befindet, analog wird die Datenleitung zum Auslesen von Informationen DL1 bis DL4 für eine Spalte an jeden Auswahltransistor einer Speicherzelle angelegt, die in einer Spalte angeordnet ist. Zum Einlesen von Informationen wird jede Speicherzelle mit Hilfe zweier zueinander inverser Schreibsignalen angesteuert. Hierzu sind pro Zeile von Speicherzellen zwei Wortleitungen WSZ1, WSZ1'...WSZ4, WSZ4' vorhanden, die jeweils an einen ersten und zweiten Steueranschluß der Transfergatter anzuschließen sind, die zu den Speicherzellen in der Zeile gehören. Zum Auslesen von Informationen wird zusätzlich pro Zeile eine dritte Leitung WL1...WL4 benötigt, die jeweils an den Gateanschluß des Auswahltransistors anzuschließen ist, der zu den Speicherzellen in der Zeile gehört. Ein zu der Speicherzelle gehörendes Transfergatter wird hierbei aus einer Parallelschaltung eines n- und p-Kanal-Feldeffekttransistors gebildet, wobei beide Drainanschlüsse jeweils des n-und p-Kanalfeldeffekttransistors den ersten Anschluß, beide Sourceanschlüsse der Feldeffekttransistoren den zweiten Anschluß und der Gateanschluß des p-Kanal-Feldeffekttransistors und der Gateanschluß des n-Kanal-Feldeffekttransistors den ersten bzw. zweiten Steuereingang eines Transfergatters bilden.

Die Spaltenschaltung SPS zu dem Speicherzellenfeld nach Figur 3 enthält eine Datenein- und Ausgangsschaltung DAS, DES sowie eine Spaltenauswahlschaltung SPAS. Die Datenein-Ausgangsschaltung wird weiterhin unterteilt in eine Dateneingangsschaltung DES und in eine Datenausgangsschaltung DAS. Die Datenausgangsschaltung DAS weist pro Spalte je zwei Eingänge und einen gemeinsamen Ausgang ADA auf, wobei ein erster Eingang dieser zwei pro Spalte zugeordneten Eingänge jeweils mit einer Datenleitung zum Auslesen von Informationen DL1 bis DL4 aller Speicherzellen einer Spalte verbunden ist. Der zweite Eingang der zwei pro Spalte zugeordneten Eingänge wird jeweils mit Steueranschlüssen der Transfergatter in der Dateneingangsschaltung verbunden. Eine Datenausgangsschaltung nach Figur 3 enthält insgesamt fünf NAND- und zwei NOR-Gatter NANDNOR1, NANDNOR2. Die zwei pro Spalte zugeordneten Eingänge sind hierbei jeweils auf ein NAND-Gatter geschaltet und der Ausgang zweier NAND-Gatter ist mit je einem Eingang eines NOR-Gatters zu verbinden. Der Abschluß der Datenausgangsschaltung DAS bildet ein letztes NAND-Gatter NAND1, welches die Ausgänge der beiden NOR-Gatter zusammenfaßt. Die Dateneingangsschaltung DES enthält jeweils ein pro Spalte zugeordneten Transfergatter TG1...TG4. Jedes dieses Transfergatter stellt eine Verbindung zwischen der Dateneingangsleitung DE' und der jeweiligen Datenleitung zum Einlesen von Informationen DS1...DS4 in die Speicherzelle her. Sie enthält einen n- und einen p-Kanalfeldeffekttransistor, die jeweils parallel geschaltet sind, so daß einer erster Anschluß des n-Kanalfeldeffekttransistors und ein erster des p-Kanalfeldeffekttransistors mit der Dateneingangsleitung DE' und ein zweiter Anschluß des n-Kanalfeldeffekttransistors und ein zweiter Anschluß des p-Kanalfeldeffekttransistors mit der jeweiligen Datenleitung zum Einlesen von Informationen DS1... DS4 verbunden ist. Die Ansteuerung des Transfergatters erfolgt jeweils über einen Steueranschluß, der an den Gateanschluß des p-Kanalfeldeffekttransistors und über einen Inverter I5...I8 mit dem Gateanschluß des n-Kanalfeldeffekttransistors verbunden ist.

Die Spaltenauswahlschaltung SPAS enthält jeweils ein pro Spalte zugeordnetes Auswahlgatter AG1...AG4, wobei jedes Auswahlgatter mit Hilfe eines NOR-Gatter NOR9...NOR12 aufgebaut ist. Ein erster Eingang eines NOR-Gatters ist mit der Zeilenleitung Z2' und ein zweiter Anschluß des NOR-Gatters ist mit der zugehörigen Spaltenadreßleitung S1,1'...S1,4' zu verschalten, der Ausgang des betreffenden NOR-Gatters ist mit der zu der Spalte zugehörigen Steueranschluß SA1...SA4 in der Dateneingangsschaltung DES und dem jeweiligen ersten Eingang in der Datenausgangsschaltung DAS verbunden.

Der Spaltenschaltung SPS zugeführt werden jeweils die Spaltenadreßleitung S1,1', S1,2', S1,3', S1,4', eine Zeilenleitung Z2' und ein über einen Inverter zugeführten Dateneingang DE'.

Der Zeilenschaltung ZS sind jeweils vier Zeilenadreßleitungen Z1,1',Z1,2',Z1,3',Z1,4' sowie zwei Steuerleitungen jeweils zum Schreiben und Lesen SS', SL' zugeordnet. Die in Figur 3 dargestellten Anschlüsse der Speichergruppe für die Zeilenleitung Z2', den Steuerleitungen zum Schreiben und Lesen SS', SL' entsprechen in Figur 2 den Verbindungen zu SPAS2, ZLAS2, sowie dem vorselektierten Schreib-Lesesignal R/W'. Die Zeilenschaltung in Figur 3 enthält vier Zeilenmodule ZM1... ZM4, wobei je ein Zeilenmodul einer Zeile von Speicherzellen zuzuordnen ist. Ein erster und zweiter Ausgang WSZ1, WSZ1'... WSZ4, WSZ4' jedes Zeilenmoduls ZM1...ZM4 ist mit dem ersten und zweiten Steuereingang aller Transfergatter in der zugehörigen Zeile von Speicherzellen verschaltet und liefert jeweils ein zueinander inverses Steuersignal zum Einlesen von Informationen in die betreffende Speicherzelle. Ein dritter Ausgang WL1...WL4 jedes Zeilenmoduls ZM1...ZM4 ist mit einem Gateanschluß der Auswahltransistoren in der zugehörigen Zeile von Speicherzellen verbunden und ermöglicht hiermit ein Auslesen von Informationen aus der Speicherzelle. Ein erster Eingang des Zeilenmoduls ist hierbei mit der Spaltenleitung zum Lesen SL', ein zweiter Eingang mit der Spaltenleitung zum Schreiben SS' und ein dritter Eingang jedes Zeilenmoduls ZM1...ZM4 mit der zugehörigen Zeilenadreßleitung Z1,1'...Z1,4' zu verschalten.

Jedes Zeilenmodul ZM1...ZM4 enthält zwei NOR-Gatter NOR1, NOR2 ...NOR7, NOR8 und einen Inverter I9...I12, wobei ein erster Anschluß des ersten NOR-Gatters NOR1 den ersten Anschluß des Zeilenmoduls ZM1, ein erster Anschluß des zweiten NOR-Gatters NOR2 den zweiten Anschluß eines Zeilenmoduls ZM1 und ein zweiter Anschluß des ersten NOR-Gatters NOR1 und ein zweiter Anschluß des zweiten NOR-Gatters NOR2 gemeinsam den dritten Eingang eines Zeilenmoduls ZM1 bilden. Ein Ausgang des ersten NOR-Gatters bildet den ersten Ausgang WSZ1, wobei der Ausgang des ersten NOR-Gatters über einen weiteren Inverter den zweiten Ausgang WSZ1' jeweils eines Zeilenmoduls ZM1 darstellt. Der Ausgang des zweiten NOR-Gatters NOR2 bildet schließlich den dritten Ausgang WL1 eines Zeilenmoduls ZM1. Alle die in der Figur 3 angegebenen Anschlüsse wie S1,1'...S1,4', Z2', DE', Z1,1'...Z1,4', SS', und SL' werden hierbei mit "active low"-Signalen beschaltet.

Für eine Speichergruppe die mit Hilfe von Speicherzellen gemäß Figur 2 und Figur 3 aus der Patentanmeldung EP-A-0 393 435 "Statische Speicherzelle" aufgebaut werden und n-Kanalauswahltransistoren an der Schreibwortleitung enthalten, entfallen die vier mit inversen Signalen betriebenen Wortleitungen WSZ1' ...WSZ4' zum Schreiben sowie die vier zugehörigen Inverter I9 ...I12.

Figur 4 zeigt die Ausführung aus Figur 3 auf Transistorebene unter Verwendung komprimierter Mehrfunktionsgatter. In der weiteren Ausführung auf Transistorebene ist es möglich, die Gatter der Dekodier- und Leseschaltungen zu komplexeren logischen Verknüpfungen zusammenzuziehen. Für Speicherzellen, die nach Figur 2 und Figur 3 der Patentanmeldung EP-A-0 393 435 "Statische Speicherzelle" mit n-Kanalauswahltransistoren an der Schreibwortleitung entfallen wiederum die vier mit inversen Signalen betriebenen Schreibwortleitungen WSZ1"...WSZ4" sowie die vier zugehörigen Inverter I9...I12.

Ein Beispiel für die flächengünstige Realisierung durch die Verwendung von speziellen Gattern sind die NAND-NOR-Gatter NANDNOR1, NANDNOR2 in Pseudo-NMOS-Technik im Datenausgangspfad. Im Gegensatz zu üblichen Pseudo-NMOS-Gattern ist hier der statische Leistungsverbrauch im Vergleich zu CMOS-Gattern nicht erheblich, da das Gatter immer nur in einem Zellblock des gesamten Speichers aktiviert ist, bzw. bei einer Speicherorganisation mit Bitbreite n in n-Zellblöcken. Ein anderer möglicher Nachteil von Pseudo-NMOS-Gattern liegt darin, daß sie keine vollen CMOS-Ausgangspegel liefern. Dadurch kann die Störsicherheit verringert werden. Um dies zu verhindern, können bei der vorgeschlagenen Anwendung im Datenausgangspfad des Speichers Pseudo-NMOS-Schaltungen im Wechsel mit reinen CMOS-Gattern eingesetzt werden, die in der Schaltschwelle auf die Pseudo-NMOS-Pegel eingestellt sind und eine Pegelauffrischung bewirken.

Figur 4 enthält ein 4 x 4 Speicherfeld mit den gleichen Speicherzellen wie in der Figur 3. Ebenso ist die Spaltenschaltung in eine Dateneingangs- DES', Datenausgangsschaltung DAS' und eine Spaltenauswahlschaltung SPAS' aufgeteilt, während die Zeilenschaltung ebenso vier Zeilenmodule ZM1'...ZM4' enthält. Die Verschaltung der Zeilenmodule ZM1'...ZM4', in der Zeilenschaltung, sowie die Verschaltung der Spaltenauswahlschaltung SPAS' mit der Dateneingangs- DES' und Datenausgangsschaltung DAS' ist hierbei genauso wie in der Figur 3 vorgenommen. Als Unterschied hierzu zeigt jedoch Figur 4 die Realisierung der Zeilenmodule der Spaltenauswahlschaltung SPAS' sowie der Datenausgangsschaltung DAS' auf Transistorebene. Die zwei NAND-NOR-Gatter NANDNOR1, NANDNOR2 im Eingangsbereich der Datenausgangsschaltung DAS' enthalten jeweils vier Eingänge und einen Ausgang und enthalten einen Feldeffekttransistor ersten Leitungstyps NTR3, NTR3' und vier Feldeffekttransistoren zweiten Leitungstyps.Je zwei der vier Feldeffekttransistoren zweiten Leitungstyps PTR3, PTR4; PTR5, PTR6 bzw. PTR3',PTR4',PTR5',PTR6',sind hierbei in einem NAND-NOR-Gatter NANDNOR1 in Serie geschaltet und bilden eine erste und zweite Serienschaltung. Die erste und zweite Serienschaltung schließlich ist parallel zwischen einem Bezugspotential VSS, in diesem Falle Masse und einem gemeinsamen Anschlußpunkt AP, AP' verbunden. Der Feldeffekttransistor ersten Leitungstyps NTR3, NTR3' wird hierbei zwischen der Versorgungsspannung VDD und dem gemeinsamen Anschlußpunkt AP, AP' angeordnet, wobei der gemeinsame Anschlußpunkt AP, AP' den Ausgang des jeweiligen NAND-NOR-Gatters NANDNOR1, NANDNOR2 bildet. Ein Gateanschluß des Feldeffekttransistors ersten Leitungstyps NTR3, NTR3' ist mit dem Bezugspotential VSS (gleich Masse) verbunden und die Gateanschlüsse der Feldeffekttransistoren der ersten Serienschaltung und die Gateanschlüsse der Feldeffekttransistoren der zweiten Serienschaltung bilden je paarweise Eingänge eines NAND-NOR-Gatters. Der Ausgang beider NAND-NOR-Gatter NANDNOR1, NANDNOR2 wird über ein NAND-Gatter NAND1 zusammengeführt, wobei dieses NAND-Gatter zwei Eingänge und einen Ausgang aufweist und zwei Feldeffekttransistoren ersten Leitungstyps NTR1, NTR2 und zwei Feldeffekttransistoren zweiten Leitungstyps PTR1, PTR2 enthält. Die Feldeffekttransistoren ersten Leitungstyps NTR1, NTR2 sind in Serie geschaltet, wobei ein erster Anschluß des ersten Feldeffekttransistors ersten Leitungstyps NTR1 mit der Versorgungsspannung VDD verbunden ist und ein erster Anschluß des zweiten Feldeffekttransistors ersten Leitungstyps den Ausgang des NAND-Gatters NAND1 bildet. Ein Gateanschluß des Feldeffekttransistors ersten Leitungstyps NTR1 und ein Gateanschluß des ersten Feldeffekttransistors zweiten Leitungstyps PTR1 stellen gemeinsam den ersten Eingang des NAND-Gatters NAND1 und ein Gateanschluß des zweiten Feldeffekttransistors ersten Leitungstyps NTR2 und ein Gateanschluß des zweiten Feldeffekttransistors zweiten Leitungstyps PTR2 gemeinsam den zweiten Eingang des NAND-Gatters NAND1 dar. Der erste und zweite Feldeffekttransistor jeweils des zweiten Leitungstyps PTR1, PTR2 werden weiterhin parallel zwischen einem Bezugspotential VSS, in diesem Falle Masse, und dem ersten Anschluß des zweiten Feldeffekttransistors ersten Leitungstyps NTR2 geschaltet. Die Spaltenauswahlschaltung SPAS' ist nach Figur 4 aus vier Auswahlgattern AG1'...AG4' aufgebaut, wobei je ein Auswahlgatter einer Spalte von Speicherzellen zuzuordnen ist. Jedes Auswahlgatter enthält einen Feldeffekttransistor ersten Leitungstyps und zwei Feldeffekttransistoren zweiten Leitungstyps. Der erste Feldeffekttransistor ersten Leitungstyps NTR6 und der erste Feldeffekttransistor zweiten Leitungstyps PTR13 sind in Serie zwischen der Zeilenleitung Z2 und dem Bezugspotential VSS (in diesem Falle Masse) geschaltet. Ein Gateanschluß des ersten Feldeffekttransistor ersten Leitungstyps und ein Gateanschluß des ersten Feldeffekttransistors zweiten Leitungstyps sind gemeinsam mit der zugehörigen Spaltenadressleitung S1,1' ...S1,4' verbunden und ein zweiter Anschluß des ersten Feldeffekttransistors ersten Leitungstyps und ein zweiter Anschluß des ersten Feldeffekttransistors ersten Leitungstyps stellen den Ausgang des jeweiligen Auswahlgatters AG1'...AG4' dar. Weiterhin ist der Ausgang eines jeweiligen Auswahlgatters AG1'...AG4' über einen zweiten Feldeffekttransistor zweiten Leitungstyps PTR14 mit dem Bezugspotential VSS, in diesem Falle Masse, verschaltet. Ein Gateanschluß des zweiten Feldeffekttransistors zweiten Leitungstyps jedes Auswahlgatters AG1'. ..AG4' ist nach Figur 4 über einen gemeinsamen Inverter I14 mit der Zeilenleitung Z2 zu verbinden.

Die Zeilenschaltung enthält vier Zeilenmodule ZM1'...ZM4', wobei wiederum jedes Zeilenmodul einer Zeile von Speicherzellen zugeordnet ist. Jedes Zeilenmodul ZM1'... wird mit Hilfe von zwei Feldeffekttransistoren ersten Leitungstyps NTR4, NTR5 und vier Feldeffekttransistoren zweiten Leitungstyps PTR9...PTR12 sowie einem weiteren Inverter I13 aufgebaut. Der erste Feldeffekttransistor ersten Leitungstyps NTR5 ist hierbei mit dem ersten Feldeffekttransistor zweiten Leitungstyps PTR11 und der zweite Feldeffekttransistor ersten Leitungstyps NTR4 mit dem zweiten Feldeffekttransistor zweiten Leitungstyps PTR9 jeweils in Serie geschaltet, wobei ein erster Anschluß des ersten Feldeffekttransistors ersten Leitungstyps gemeinsam mit einem Gateanschluß des dritten Feldeffekttransitors zweiten Leitungstyps PTR10 den ersten Eingang eines Zeilenmoduls ZM1', ein erster Anschluß des zweiten Feldeffekttransistors ersten Leitungstyps NTR4 gemeinsam mit einem Gateanschluß des vierten Feldeffekttransistors zweiten Leitungstyps PTR12 den zweiten Eingang eines Zeilenmoduls ZM1' und ein Gateanschluß des ersten Feldeffekttransistors ersten Leitungstyps NTR5, ein Gateanschluß des ersten Feldeffekttransistors zweiten Leitungstyps PTR11, ein Gateanschluß des zweiten Feldeffekttransistors ersten Leitungstyps NTR4 und ein Gateanschluß des zweiten Feldeffekttransistors zweiten Leitungstyps PTR9 gemeinsam den dritten Eingang eines Zeilenmoduls ZM1' bilden. Ein erster Anschluß des ersten Feldeffekttransistors zweiten Leitungstyps PTR11 und ein erster Anschluß des zweiten Feldeffekttransistors zweiten Leitungstyps PTR9 sind gemeinsam mit einem Bezugspotential VSS (gleich Masse) verschaltet und ein zweiter Anschluß des ersten Feldeffekttransistors ersten Leitungstyps NTR5 und ein zweiter Anschluß des ersten Feldeffekttransistors zweiten Leitungstyps PTR11 bilden gemeinsam einem dritten Ausgang eines Zeilenmoduls ZM1'. Zwischen diesen dritten Ausgang und dem Bezugspotential VSS ist der dritte Feldeffekttransistor zweiten Leitungstyps PTR12 verschaltet, und ein zweiter Anschluß des zweiten Feldeffekttransistors ersten Leitungstyps NTR4 und ein zweiter Anschluß des zweiten Feldeffekttransistors zweiten Leitungstyps PTR9 bilden gemeinsam den ersten Ausgang eines Zeilenmoduls ZM1' und über einen weiteren Inverter I13 den zweiten Ausgang eines Zeilenmoduls ZM1'. Der erste Ausgang eines Zeilenmoduls wird weiterhin über den vierten Feldeffekttransistor zweiten Leitungstyps PTR10 mit dem Bezugspotential VSS verbunden.

Die Zuleitungen zur Speichergruppe sind bei den Figuren 3 und 4 unterschiedlich. In Figur 4 werden die Spalten und Zeilenleitungen S1,1'...S1,4', Z1,1'...Z1,4' sowie die Eingangsleitungen DE' mit "active low"-Signalen und die Datenleitung Z2, die Spaltenleitung zum Schreiben SS und die Spaltenleitung zum Lesen SL mit "active high"-Signalen beschaltet.

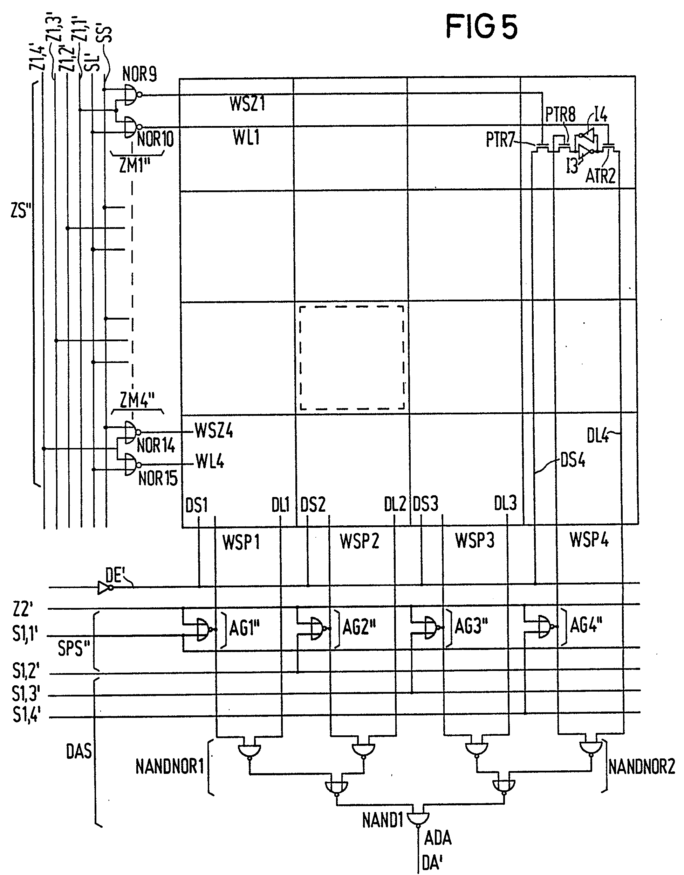

Figur 5 zeigt eine Anordnung von Speicherzellen mit zwei in Serie geschalteten Auswahltransistoren und drei Wortleitungen in einem Block aus 16 Speicherzellen eines hierarchisch aufgebauten statischen Speichers mit NAND-Gatter in der Datenausleseschaltung DAS. Ausführlich wiedergegeben ist dieser Typ von Speicherzellen in der Figur 5 der Patentanmeldung 88 E 1876 DE mit dem Titel "Statische Speicherzelle". Ein Vergleich mit den Speicherzellen aus Figur 4 zeigt, daß die Ausführung einer zusätzlichen Wortspaltenleitung WSP1...WSP4 in Spaltenrichtung zu erheblichen Einsparungen in der Peripherie der Zeilenschaltung ZS" führt. Insbesondere werden vier Inverter zur Erzeugung der inversen Wortschreibsignale und vier Transfergatter zur Ansteuerung der Datenleitungen zum Einlesen von Informationen in die Speicherzelle eingespart. Statt den vier Wortschreibleitungen werden hier vier Wortspaltenleitungen WSP1...WSP4 benötigt. Die Ausführung auf der Transistorebene entspricht der Figur 4 beim Fortfall der obengenannten Gatter.

Nach Figur 5 enthält das Speicherzellenfeld ebenso 4 x 4 Speicherzellen, wobei jede Speicherzelle zwei in Serie geschaltete Auswahltransistoren PTR7, PTR8 zum Einlesen von Informationen in die Speicherzelle, zwei Inverter I3, I4 und einen Auswahltransistor ATR2 zum Auslesen von Informationen aus der Speicherzelle enthält. Die zwei in Serie geschalteten Auswahltransistoren PTR7, PTR8 sind zwischen der zu der Spalte der Speicherzelle zugehörigen Datenleitung DS1...DS4 zum Einlesen von Informationen und einem Eingang des ersten Inverters I3 geschaltet. Der zweite Inverter I4 wird hierbei auf den ersten Inverter I3 rückgekoppelt und der Auswahltransistor ATR2 ist zwischen einem Ausgang des ersten Inverters I3 und der zu der Spalte der Speicherzelle zugehörigen Datenleitung zum Auslesen von Informationen DL4 anzuschließen. Die Speicherzelle mit zwei seriellen Schreibauswahltransistoren PTR7, PTR8 ist besonders störsicher gegen Produktionstoleranzen und Technolo-gieänderungen. Durch den Einsatz der hierarchischen Architektur mit kurzen Datenleitungen kann auch die Leseschaltung so störsicher ausgeführt werden wie die sehr robuste CMOS-Logik. Ein so entworfener statischer Speicher ist ohne Entwurfsänderung für mehrere Technologiegenerationen innerhalb eines "Shrink-pfades" skalierbar und behält auch bei einer reduzierten Versorgungsspannung noch seine Funktionssicherheit.

Die Verschaltung der Speicherzellen zu einem Speicherzellenfeld entspricht der in Figur 3 bzw. in Figur 4. Jedoch entfällt hierbei die mit inversen Signalen betriebene Schreibwortleitung, da die Speicherzelle kein Transfergatter enthält. Stattdessen ist pro Spalte im Speicherzellenfeld eine Spaltenwortleitung WSP1...WSP4 enthalten, die mit jeder Speicherzelle in der Spalte so zu verschalten ist, daß sie einerseits mit dem Gateanschluß des zweiten der zwei in Serie geschalteten Auswahltransistoren PTR8 zum Einlesen von Informationen und andererseits mit dem Ausgang des zu dieser Spalte zugehörigen Auswahlgatters AG4" verbunden ist. Der Aufbau der Spaltenschaltung SPS" enthält hierbei eine Datenausgangsschaltung DAS, sowie eine Spaltenauswahlschaltung. Diese Spaltenauswahlschaltung ist genauso wie in Figur 3 mit Auswahlgatter AG1"... AG4" aufgebaut und enthält daher jeweils ein NOR-Gatter pro Spalte. Durch den Wegfall der Transfergatter ist die Dateneingangsleitung DE' direkt mit der Datenleitung der betreffenden Spalte zum Einlesen von Informationen DS1...DS4 verbunden.

Die Zeilenschaltung ZS" enthält ebenso wie Figur 3 jeweils ein pro Zeile zugeordnetes Zeilenmodul ZM1"...ZM4", wobei die einzelnen Zeilenmodule mit den Zeilenadreßleitungen Zl,l' ...Z1,4', der Spaltenleitung zum Lesen SL' und der Spaltenleitung zum Schreiben SS' genauso wie in der Figur 3 zu verschalten ist. Jedes Zeilenmodul enthält hierbei zwei NOR-Gatter NOR9, NOR10 bis NOR14, NOR15 wobei ein Ausgang des ersten NOR-Gatters NOR9 den ersten Ausgang, ein Ausgang des zweiten NOR-Gatters NOR10 den zweiten Ausgang jeweils eines Zeilenmoduls ZM1" bilden. Ein erster Eingang des ersten NOR-Gatters NOR9 bildet den ersten Eingang eines Zeilenmoduls ZM1" und ein erster Eingang des zweiten NOR-Gatters NOR10 den zweiten Eingang eines Zeilenmoduls ZM1". Ein zweiter Eingang des ersten NOR-Gatters NOR9 ist gemeinsam mit einem zweiten Eingang des zweiten NOR-Gatters NOR10 verschaltet und bildet den dritten Eingang eines Zeilenmoduls ZM1". Alle Leitungen der Speichergruppe sind ebenso wie in Figur 3 mit "active low"-Signalen beschaltet.

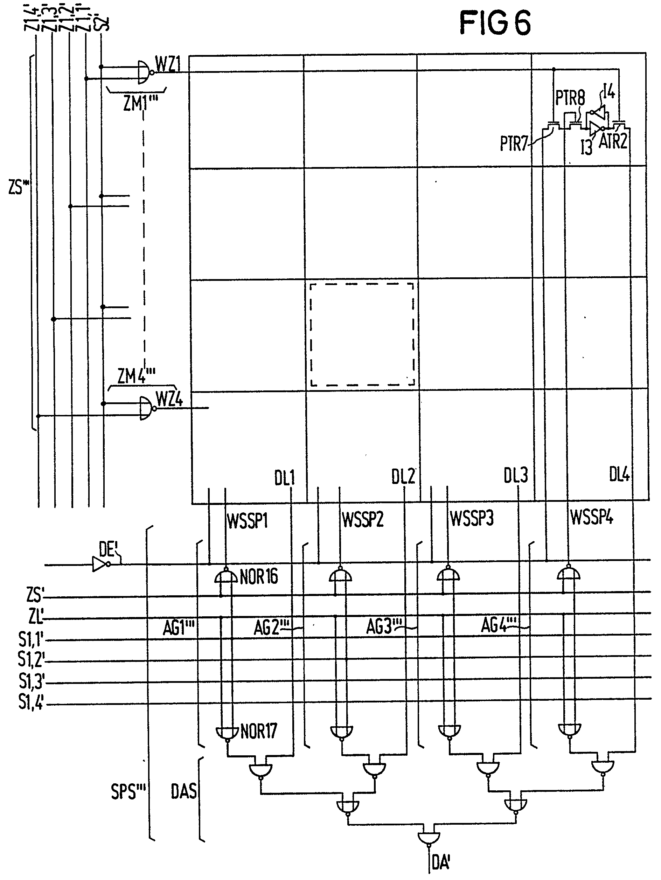

Figur 6 zeigt eine Anordnung von Speicherzellen mit zwei in Serie geschalteten Auswahltransistoren und zwei Wortleitungen. Dieser Typ von Speicherzellen ist in der Figur 6 der Erfindungsmeldung 88 E 1876 DE, "Statische Speicherzelle" ebenfalls ausführlich beschrieben. Wie schon bereits in dieser genannten Patentanmeldung wiedergegeben wird hier der Schaltungsaufwand von der Zeilendecodierung in die Spaltendecodierung verlagert. Im Vergleich zu der Figur 5 entfallen hierbei die vier NOR-Gatter NOR10...NOR15, die die Lesewortleitung WL1... WL4 ansteuern. Dafür sind vier NOR-Gatter zur Verknüpfung der Spaltenwortleitung WSSP1...WSSP4 mit der Schreibauswahl erforderlich. Die einzelne Zeilenwortleitung wird hier mit der doppelten Anzahl von Auswahltransistorgates belastet. Dafür wird hier jedoch Zellfläche eingespart. Gerade beim hierarchischen statischen Speicher mit kleinen Zellblöcken in der ersten Hierarchieebene muß daher die resultierende Gesamtfläche und die Gesamtverzögerungszeit der Varianten zwischen der Figur 5 und der Figur 6 sorgfältig verglichen werden. In der Verschaltung der Speicherzellen in dem Speicherzellenfeld ist lediglich gegenüber Figur 5 pro Zeile eine Schreib/Lesewortleitung WZ1...WZ4, die mit jeder Speicherzelle in der Zeile so verschaltet ist, daß sie mit dem Gateanschluß des ersten der zwei in Serie geschalteten Auswahltransistoren PTR7... zum Einlesen von Informationen in die Speicherzellen und gleichzeitig mit dem Gateanschluß des Auswahltransistors ATR2 zum Auslesen von Informationen aus den Speicherzellen verbunden ist.

Der Speichergruppe in Figur 6 wird hierbei eine Spaltenleitung S2', eine Zeilenleitung zum Lesen ZL', eine Zeilenleitung zum Schreiben ZS', eine Dateneingangs- DE' und eine Datenausgangsleitung DA' zugeordnet. Der Aufbau der Spaltenschaltung SPS‴ teilt sich auf eine Datenausgangsschaltung DAS sowie eine Spaltenauswahlschaltung, die je ein pro Spalte zugeordnetes Auswahlgatter AG1‴...AG4‴ enthält. Die Datenausgangsschaltung DAS ist genau wie in den vorhergehenden Figuren aufzubauen, während ein Auswahlgatter AG1‴ zwei NOR-Gatter NOR16, NOR17 enthält, wobei ein Ausgang des ersten NOR-Gatters NOR16 den ersten Ausgang eines Auswahlgatters AG1‴ und ein Ausgang des zweiten NOR-Gatters NOR17 den zweiten Ausgang eines Auswahlgatters AG1‴ bilden. Ein erster Eingang eines ersten NOR-Gatters NOR 16 bildet den ersten Eingang eines Auswahlgatters AG1‴ und ein erster Eingang des zweiten NOR-Gatters NOR17 einen zweiten Eingang des Auswahlgatters. Ein zweiter Eingang des ersten NOR-Gatters NOR 16 und ein zweiter Eingang des zweiten NOR-Gatters NOR17 sind gemeinsam mit dem dritten Eingang eines Auswahlgatters AG1‴ verschaltet.

Der erste Eingang eines Auswahlgatters AG1‴ ist mit der Zeilenleitung zum Schreiben ZS', der zweite Eingang desselben mit der Zeilenleitung zum Lesen ZL' zu verbinden. Der dritte Eingang eines Auswahlgatters AG1‴ wird mit der betreffenden Spaltenadreßleitung S1,1' angeschlossen. Schließlich ist der erste Ausgang eines Auswahlgatters AG1‴ mit der zugehörigen Spaltenwortleitung WSSP1 und der zweite Ausgang desselben mit dem ersten der zwei pro Spalte zugeordneten Eingängen der Datenausgangsschaltung DAS zu verschalten.

Die Zeilenschaltung ZS‴ enthält vier Zeilenmodule ZM1‴... ZH4‴, wobei je ein Zeilenmodul einer Zeile von Speicherzellen wiederum zugeordnet ist. Ein Ausgang jedes Zeilenmoduls ZM1‴ ist mit einem Gateanschluß jedes ersten der zwei in Serie geschalteten Auswahltransistoren PTR7... zum Einlesen von Informationen der zugehörigen Zeile von Speicherzellen und mit einem Gateanschluß jedes Auswahltransistors ATR2... zum Auslesen von Informationen der zugehörigen Zeile von Speicherzellen zu verbinden. Ein erster Eingang eines jeden Zeilenmoduls ZM1‴ ist mit der Spaltenleitung S2' und ein zweiter Eingang eines jeden Zeilenmoduls ZM1‴ mit der zugehörigen Zeilenadreßleitung Z1,1' anzuschließen. Jedes Zeilenmodul enthält ein NOR-Gatter wobei ein Ausgang des NOR-Gatters den Ausgang eines Zeilenmoduls ZM1‴ und ein erster und zweiter Eingang eines NOR-Gatters den ersten und zweiten Eingang eines Zeilenmoduls ZM1‴ bildet.

## Patentansprüche

1. Ein aus Speicherzellen hierarchisch aufgebauter Speicher , der in mehr als zwei Hierarchieebenen (H0, H1 ... H3) aufgeteilt ist, bei dem ein Element der ersten Hierarchieebene (H0) eine Speicherzelle ist, ein Element der zweiten Hierarchieebene (H1) eine Gruppe von Speicherzellen ist und ein Element jeder nächsthöheren Hierarchieebene aus einer Gruppe von Elementen der nächstniederen Hierarchieebene aufgebaut ist, bei dem jeder Hierarchieebene eine Spalten- und Zeilenschaltung zum Ansteuern, Lesen und Schreiben der Elemente der Hierarchieebene zugeordnet ist,
**dadurch gekennzeichnet**,
- daß die Zeilenschaltungen (ZS1 ... ZS3) und die Spaltenschaltungen (SPS1 ... SPS3) auf jeder Hierarchieebene unterschiedlich ausgebildet sind,
- daß die Zeilenschaltung (ZS1) der zweiten Hierarchieebene (H1) lediglich in einer ersten Zeilenauswahlschaltung (ZLAS1) und die Spaltenschaltung (SPS1) der zweiten Hierarchieebene (H1) lediglich in einer ersten Spaltenauswahlschaltung (SPAS1) und in einer Datenein- und -ausgangsschaltung (D1I/0) besteht, wobei die Zeilenschaltung (ZS1) der zweiten Hierarchieebene (H1) aus Zeilenmodulen (ZM1 ... ZM4) besteht, die lediglich aus einem jeweiligen Zeilenadreßsignal (Z1,1'), abhängig von einem Lesesignal (SL') und einem Schreibsignal (SS') mindestens ein Schreibsignal (WSZ1, WSZ1') für ein Wort oder ein Lesesignal (WL1) für ein Wort bilden,
- daß die Zeilenschaltung (ZS2) der dritten Hierarchieebene (H2) in einer zweiten Zeilenauswahlschaltung (ZLAS2) und in einer Zeilen-Vorselektionseinrichtung (VSZ2) sowie die Spaltenschaltung (SPS2) der dritten Hierarchieebene (H2) in einer Zweiten Spaltenauswahlschaltung (SPAS2) und in einer Spalten-Vorselektionseinrichtung (VSS2) besteht, und pro Zeile eine Datenein- und -ausgangsschaltung (D2I/0) vorgesehen ist,
- daß die Zeilenschaltung (ZS3) der vierten Hierarchieebene (H3) in einer dritten Zeilenauswahlschaltung (ZLAS3), einem Zeilen-Verstärker (VZ3) und einer Zeilen-Vorselektionseinrichtung (DEVZ3) besteht, daß die Spaltenschaltung (SPS3) der vierten Hierarchieebene (H3) aus einer dritten Spaltenauswahlschaltung (SPAS3), einem Spalten-Verstärker mit Zwischenspeicher (VS3) sowie einer Spalten-Dekodier- und Vorselektiereinrichtung (DEVS3) besteht,
- daß eine Adresse entsprechend den Hierarchieebenen in erste, zweite und dritte Zeilen- und Spaltenadressen (AWO-2, ABO-2; AW3-4, AB3-4; AW5-6, AB5-6) aufgeteilt ist,
- daß in der vierten Hierarchiebene (H3)
die dritten Zeilen- und Spaltenauswahlschaltungen (ZLAS3, SPAS3) anhand der dritten Zeilen- und Spaltenadressen (AW5-6, AB5-6) ein Element (1K) der dritten Hierarchieebene (H2) auswählen,
die Verstärker (VZ3, VS3) die zweiten Zeilen- und Spaltenadressen (AW3-4, AB3-4) verstärken,
die Dekodiereinrichtungen (DEVZ3, DEVS3) die ersten Zeilen- und Spaltenadressen (AWO-2, ABO-2) dekodieren,
und die Vorselektionseinrichtungen (DEVZ3, DEVS3) die dekodierten ersten Zeilen- und Spaltenadressen anhand der getroffenen Elementauswahl vorselektieren,
- daß in der dritten Hierarchiebene (H2)
die zweiten Zeilen- und Spaltenauswahlschaltungen (ZLAS2, SPAS2) anhand der zweiten Zeilen- und Spaltenadressen (AW3-4, AB3-4) ein Element (64) der zweiten Hierarchiebene (H1) auswählen,
und die Vorselektionseinrichtungen (VSZ2, VSS2) die dekodierten ersten Zeilen- und Spaltenadressen (AB0-2, AW0-2) anhand der getroffenen Elementauswahl vorselektieren, und
- daß in der zweiten Hierarchieebene (H1)
die ersten Zeilen- und Spaltenauswahlschaltungen (ZLAS1, SPAS1) anhand der dekodierten ersten Zeilen- und Spaltenadressen (AW0-2, AB0-2) ein Element der ersten Hierarchiebene (HO) auswählen.

2. Ein aus Speicherzellen hierarchisch aufgebauter Speicher nach Anspruch 1, **dadurch gekennzeichnet,** daß die Speicherzellen statische Speicherzellen sind und daß jede Speicherzelle mit einer Datenleitung zum Einlesen von Informationen (DS1...DS4) in die Speicherzelle und mit einer Datenleitung zum Auslesen von Informationen (DL1...DL4) aus der Speicherzelle ausgestattet ist.

3. Ein aus Speicherzellen hierarchisch aufgebauter Speicher nach Anspruch 1 oder 2, **dadurch gekennzeichnet,** daß Dekoderschaltungen für Spaltenadreß und Zeilenadreßleitungen in der Spalten- und Zeilenschaltung der niederen Hierarchieebene (H2) in einer höheren oder höchsten Hierarchieebene (H3) realisiert sind.

4. Ein aus Speicherzellen hierarchisch aufgebauter Speicher nach Anspruch 3, dadurch gekennzeichnet, daß die zweite Hierarchieebene aus einer Speichergruppe mit n·m Speicherzellen (n, m = ganze Zahl) in Zeilen und Spalten aufgebaut ist und die Speichergruppe n Zeilenadreßleitungen und m Spaltenadreßleitungen zugeordnet sind, daß eine Spaltenschaltung (SPS) der zweiten Hierarchieebene eine Datenauswerteschaltung (DAS) enthält, wobei letztere pro Spalte zwei Eingänge und einen gemeinsamen Ausgang (ADA) aufweist, von denen jeweils ein erster Eingang mit einer Datenleitung zum Auslesen von Informationen (DL1 ... DL4) aus den Speicherzellen einer Spalte verbunden ist, und jeweils ein zweiter Eingang mit einem Steueranschluß (SA1 ... SA) der Spaltenauswahlschaltung (SPAS) verbunden und auf diese Weise eine der Datenleitungen (DL1 ... DL4) ausgewählt ist, daß die zwei Eingänge pro Spalte über NAND-NOR-Gatter (NANDNOR1, NANDNOR2) miteinander verknüpft werden und die Ausgänge der NAND-NOR-Gatter (NANDNOR1, NANDNOR2) über NAND-Gatter (NAND1) auf den gemeinsamen Ausgang (ADA) der Datenauswerteschaltung (DAS) geschaltet sind.

5. Ein aus Speicherzellen hierarchisch aufgebauter Speicher nach Anspruch 4, **dadurch gekennzeichnet** , daß das NAND-Gatter (NAND1) mit zwei Eingängen und einem Ausgang zwei Feldeffekttransistoren des ersten Leitungstyps (NTR1, NTR2) und zwei Feldeffekttransistoren des zweiten Leitungstyps (PTR1, PTR2) enthält, daß die Feldeffekttransistoren des ersten Leitungstyps (NTR1, NTR2) in Serie geschaltet sind, wobei ein erster Anschluß des ersten Feldeffekttransistors ersten Leitungstyps (NTR1) mit der Versorgungsspannung (VDD) verbunden ist und ein erster Anschluß des zweiten Feldeffekttransistors ersten Leitungstyps (NTR2) den Ausgang des NAND-Gatters (NAND1) bildet, daß ein Gateanschluß des ersten Feldeffekttransistors ersten Leitungstyps (NTR1) und ein Gateanschluß des ersten Feldeffekttransistors zweiten Leitungstyps (PTR1) gemeinsam den ersten Eingang des NAND-Gatters (NAND1) und ein Gateanschluß des zweiten Feldeffekttransistors ersten Leitungstyps (NTR2) und ein Gateanschluß des zweiten Feldeffekttransistors zweiten Leitungstyps (PTR2) gemeinsam den zweiten Eingang des NAND-Gatters (NAND1) darstellen, daß der erste und zweite Feldeffekttransistor zweiten Leitungstyps (PTR1, PTR2) parallel zwischen einem Bezugspotential (VSS) und dem ersten Anschluß des zweiten Feldeffekttransistors ersten Leitungstyps (NTR2) geschaltet sind.

6. Ein aus Speicherzellen hierarchisch aufgebauter Speicher nach Anspruch 4, **dadurch gekennzeichnet** , daß das NAND-NOR-Gatter (NANDNOR1; NANDNOR2) mit vier Eingängen und einem Ausgang, einem Feldeffekttransistor ersten Leitungstyps (NTR3; NTR3') und vier Feldeffekttransistoren zweiten Leitungstyps (PTR3, PTR4, PTR5, PTR6; PTR3', PTR4', PTR5', PTR6') enthält, daß je zwei der vier Feldeffekttransistoren zweiten Leitungstyps (PTR3, PTR4; PTR5, PTR6; PTR3', PTR4'; PTR5', PTR6') in Serie geschaltet sind und eine erste und zweite Serienschaltung bilden, daß die erste und zweite Serienschaltung parallel zwischen einem Bezugspotential (VSS) und einem gemeinsamen Anschlußpunkt (AP, AP') verschaltet sind, daß der Feldeffekttransistor ersten Leitungstyps (NTR3; NTR3') zwischen der Versorgungsspannung (VDD) und dem gemeinsamen Anschlußpunkt (AP, AP') angeordnet ist, und der gemeinsame Anschlußpunkt (AP, AP') den Ausgang des NAND-NOR-Gatters bildet, daß ein Gateanschluß des Feldeffekttransistors ersten Leitungstyps (NTR3; NTR3') mit dem Bezugspotential (VSS) verbunden ist und Gateanschlüsse der Feldeffekttransistoren der ersten Serienschaltung und Gateanschlüsse der Feldeffekttransistoren der zweiten Serienschaltung je paarweise Eingänge des NAND-NOR-Gatters (NANDNOR1, NANDNOR2) bilden, die mit den zwei Eingängen pro Spalte der Datenauswerteschaltung (DAS) zu verschalten sind.

7. Ein aus Speicherzellen hierarchisch aufgebauter Speicher nach einem der Ansprüche 3 bis 6, **dadurch gekennzeichnet** , daß jede Speicherzelle der Speichergruppe ein Transfergatter (TG), zwei Inverter (I1, I2) und einen Auswahltransistor (ATR1) enthält, daß das Transfergatter (TG) zwischen der zu der Spalte der Speicherzelle zugehörigen Datenleitung zum Einlesen von Informationen (DS1...DS4) und einem Eingang des ersten Inverters (I1) geschaltet ist, daß der zweite Inverter (I2) auf den ersten Inverter (I1) rückgekoppelt ist und der Auswahltransistor (ATR1) zwischen einem Ausgang des ersten Inverters (I1) und der zu der Spalte der Speicherzelle zugehörigen Datenleitung zum Auslesen von Informationen (DL1...DL4) geschaltet ist.

8. Ein aus Speicherzellen hierarchisch aufgebauter Speicher nach einem der Ansprüche 3 bis 6, **dadurch gekennzeichnet** , daß jede Speicherzelle der Speichergruppe zwei in Serie geschaltete Auswahltransistoren (PTR7, PTR8) zum Einlesen von Informationen in die Speicherzelle, zwei Inverter (I3, I4) und ein Auswahltransistor (ATR2) zum Auslesen von Informationen aus der Speicherzelle enthält, daß die zwei in Serie geschalteten Auswahltransistoren (PTR7, PTR8) zwischen der zu der Spalte der Speicherzelle zugehörigen Datenleitung zum Einlesen von Informationen (DS1...DS4) und einem Eingang des ersten Inverters (I3) geschaltet ist, daß der zweite Inverter (I4) auf den ersten Inverter (I3) rückgekoppelt ist und der Auswahltransistor (ATR2) zwischen einem Ausgang des ersten Inverters (I3) und der zu der Spalte der Speicherzelle zugehörigen Datenleitung zum Auslesen von Informationen (DL1...DL4) geschaltet ist.

9. Ein aus Speicherzellen hierarchisch aufgebauter Speicher nach Anspruch 7, **dadurch gekennzeichnet** , daß der Speichergruppe eine Spaltenleitung zum Lesen ( SL'), eine Spaltenleitung zum Schreiben (SS'), eine Zeilenleitung (Z2'), eine Dateneingangsleitung (DE') und eine Datenausgangsleitung (DA') zugeordnet sind, daß die Zeilenschaltung (ZS) n Zeilenmodule (ZM1...ZM4) enthält, wobei je ein Zeilenmodul einer Zeile von Speicherzellen zugeordnet ist, daß ein erster und zweiter Ausgang jedes Zeilenmoduls (ZM1...ZM4) mit einem ersten und zweiten Steuereingang aller Transfergatter (TG) in der zugehörigen Zeile von Speicherzellen verschaltet ist und ein dritter Ausgang mit einem Gateanschluß aller Auswahltransistoren (ATR1) in der zugehörigen Zeile von Speicherzellen verbunden ist, daß ein erster Eingang jeden Zeilenmoduls (ZM1...ZM4) mit der Spaltenleitung zum Lesen (SL'), ein zweiter Eingang jedes Zeilenmoduls (ZM1...ZM4) mit der Spaltenleitung zum Schreiben (SS') und ein dritter Eingang jeden Zeilenmoduls (ZM1...ZM4) mit der zugehörigen Zeilenadreßleitung (Z1,1'...Z4,4') zu verschalten ist, daß die Spaltenschaltung (SPS) m Transfergatter (TG1...TG4) und m Auswahlgatter (AG1... AG4) enthält, wobei je ein Transfergatter und je ein Auswahlgatter einer Spalte von Speicherzellen zugeordnet ist, daß jedes Transfergatter (TG1...TG4) zwischen der Dateneingangsleitung (DE') und der zu der Spalte zugehörigen Datenleitung zum Einlesen von Informationen (DS1...DS4) geschaltet ist, daß jedes Transfergatter einem gemeinsamen Steueranschluß (SA1... SA4) zugeordnet ist, der einerseits direkt mit einem ersten Steuereingang und über einen Inverter (I5...I8) mit einem zweiten Steuereingang des zugehörigen Transfergatters (TG1...TG4) verschaltet ist und der andererseits mit einem Ausgang des zugehörigen Auswahlgatters (AG1...AG4) und einem der zwei pro Spalte zugeordneten Eingängen der Datenauswerteschaltung (DAS) verbunden ist und daß jedes Auswahlgatter (AG1...AG4) mit einem ersten Anschluß mit der Zeilenleitung (Z2') und mit einem zweiten Anschluß mit der zugehörigen Spaltenadreßleitung (S1,1'... S1,4') zu verschalten ist.

10. Ein aus Speicherzellen hierarchisch aufgebauter Speicher nach Anspruch 9, **dadurch gekennzeichnet** , daß jedes Zeilenmodul (ZM1...ZM4) zwei NOR-Gatter (NOR1, NOR2;...; NOR7, NOR8) und einen Inverter (I9...I12) enthält, daß ein erster Anschluß des ersten NOR-Gatters den ersten Anschluß eines Zeilenmoduls (ZM1), ein erster Anschluß des zweiten NOR-Gatters (NOR2) den zweiten Anschluß eines Zeilenmoduls (ZM1) und ein zweiter Anschluß des ersten und ein zweiter Anschluß des zweiten NOR-Gatters (NOR1, NOR2) gemeinsam den dritten Eingang eines Zeilenmoduls (ZM1) bilden, daß ein Ausgang des ersten NOR-Gatters (NOR1) den ersten Ausgang und über einen weiteren Inverter (I9) den zweiten Ausgang jeweils eines Zeilenmoduls (ZM1) darstellt und ein Ausgang des zweiten NOR-Gatters (NOR2) den dritten Ausgang eines Zeilenmoduls (ZM1) bildet, daß jedes Auswahlgatter (AG1...AG4) mit Hilfe jeweils eines NOR-Gatters (NOR9...NOR12) aufgebaut ist, wobei ein Ausgang eines NOR-Gatters (NOR9...NOR12) den Ausgang eines Auswahlgatters (AG1...AG4) und ein erster und zweiter Eingang eines NOR-Gatters (NOR9...NOR12) den ersten und zweiten Eingang eines Auswahlgatters (AG1...AG4) darstellen, und daß die Zeilenadreßleitungen (Z1,1'...Z1,4'), die Spaltenadreßleitungen (S1,1'...S1,4'), die Spaltenleitung zum Lesen (SL'), die Spaltenleitung zum Schreiben (SS'), die Zeilenleitung (Z2') und die Datenausgangsleitung (DE') mit "active low"-Signalen beschaltet sind.

11. Ein aus Speicherzellen hierarchisch aufgebauter Speicher nach Anspruch 9, **dadurch gekennzeichnet** , daß jedes Zeilenmodul (ZM1'...ZM4') zwei Feldeffekttransistoren ersten Leitungstyps (NTR4, NTR5) und vier Feldeffekttransistoren zweiten Leitungstyps (PTR9...PTR12) und einen Inverter (I13) enthält, daß der erste Feldeffekttransistor ersten Leitungstyps (NTR5) mit dem ersten Feldeffekttransistor zweiten Leitungstyps (PTR11) und der zweite Feldeffekttransistor ersten Leitungstyps (NTR4) mit dem zweiten Feldeffekttransistor zweiten Leitungstyps (PTR9) jeweils in Serie geschaltet sind, wobei ein erster Anschluß des ersten Feldeffekttransistor ersten Leitungstyps (NTR5) gemeinsam mit einem Gateanschluß des dritten Feldeffekttransistor zweiten Leitungstyps (PTR10) den ersten Eingang eines Zeilenmoduls (ZM1'), ein erster Anschluß des zweiten Feldeffekttransistors ersten Leitungstyps (NTR4) gemeinsam mit einem Gateanschluß des vierten Feldeffekttransistors zweiten Leitungstyps (PTR12) den zweiten Eingang eines Zeilenmoduls und ein Gateanschluß des ersten Feldeffekttransistors ersten Leitungstyps (NTR5), ein Gateanschluß des ersten Feldeffekttransistors zweiten Leitungstyps (PTR11), ein Gateanschluß des zweiten Feldeffekttransistors ersten Leitungstyps (NTR4) und ein Gateanschluß des zweiten Feldeffekttransistors zweiten Leitungstyps (PTR9) gemeinsam den dritten Eingang eines Zeilenmoduls bilden, daß ein erster Anschluß des ersten Feldeffekttransistors zweiten Leitungstyps (PTR11) und ein erster Anschluß des zweiten Feldeffekttransistors zweiten Leitungstyps (PTR9) gemeinsam mit einem Bezugspotential (VSS) verschaltet sind, daß ein zweiter Anschluß des ersten Feldeffekttransistors ersten Leitungstyps (NTR5) und ein zweiter Anschluß des ersten Feldeffekttransistors zweiten Leitungstyps (PTR11) gemeinsam den dritten Ausgang eines Zeilenmoduls (ZM1') bilden, wobei zwischen diesen und dem Bezugspotential (VSS) der dritte Feldeffekttransistor zweiten Leitungstyps (PTR12) verschaltet ist, daß ein zweiter Anschluß des zweiten Feldeffekttransistors ersten Leitungstyps (NTR4) und ein zweiter Anschluß des zweiten Feldeffekttransistors zweiten Leitungstyps (PTR9) gemeinsam den ersten Ausgang eines Zeilenmoduls (ZM1') und über einen weiteren Inverter (I13) den zweiten Ausgang eines Zeilenmoduls (ZM1') darstellen, wobei der erste Ausgang eines Zeilenmoduls über den vierten Feldeffekttransistor zweiten Leitungstyps (PTR10) mit dem Bezugspotential (VSS) verschaltet ist, daß jedes Auswahlgatter (AG1'... AG4') ein Feldeffekttransistor ersten Leitungstyps (NTR6) und zwei Feldeffekttransistoren zweiten Leitungstyps (PTR13, PTR14) enthält, wobei der erste Feldeffekttransistor ersten Leitungstyps (NTR6) und der erste Feldeffekttransistor zweiten Leitungstyps (PTR13) in Serie zwischen der Zeilenleitung (Z2) und dem Bezugspotential (VSS) geschaltet ist, daß ein Gateanschluß des ersten Feldeffekttransistors ersten Leitungstyps (NTR6) und ein Gateanschluß des ersten Feldeffekttransistors zweiten Leitungstyps (PTR13) gemeinsam mit einer zugehörigen Spaltenadreßleitung (S1,1') verschaltet ist und ein zweiter Anschluß des ersten Feldeffekttransistors ersten Leitungstyps (NTR6) und ein zweiter Anschluß des ersten Feldeffekttransistors zweiten Leitungstyps (PTR13) den Ausgang eines Auswahlgatters (AG1') darstellen, wobei dieses über einen zweiten Feldeffekttransistors zweiten Leitungstyps (PTR14) mit dem Bezugspotential (VSS) verschaltet ist und ein Gateanschluß des zweiten Feldeffekttransistors zweiten Leitungstyps (PTR14...) jedes Auswahlgatters (AG1'...AG4') über einen Inverter (I14) mit der Zeilenleitung (Z2) verbunden ist, daß die Zeilenadreßleitungen (Z1,1'...Z1,4'), die Spaltenadreßleitungen (S1,1'... S1,4'), sowie die Dateneingangsleitung (DE') mit "active low"-Signalen und die Zeilenleitung (Z2), die Spaltenleitung zum Schreiben (SS) und die Spaltenleitung zum Lesen (SL) mit "active high"-Signalen beschaltet sind.

12. Ein aus Speicherzellen hierarchisch aufgebauter Speicher nach einem der vorhergehenden Ansprüche, **dadurch gekennzeichnet**, daß ein Transfergatter aus einem Feldeffekttransistor ersten Leitungstyps und einem Feldeffekttransistor zweiten Leitungstyps aufgebaut ist, daß der Feldeffekttransistor ersten Leitungstyps parallel mit dem Feldeffekttransistor zweiten Leitungstyps verschaltet ist und ein Gateanschluß des Feldeffekttransistors zweiten Leitungstyps den zweiten Steuereingang und ein Gateanschluß des Feldeffekttransistors ersten Leitungstyps den ersten Steuereingang eines Transfergatters bilden.

13. Ein aus Speicherzellen hierarchisch aufgebauter Speicher nach Anspruch 8, **dadurch gekennzeichnet** , daß der Speichergruppe eine Spaltenleitung zum Lesen (SL'), eine Spaltenleitung zum Schreiben (SS'), eine Zeilenleitung (Z2'), eine Dateneingangs- (DE') und eine Datenausgangsleitung (DA') zugeordnet ist, daß die Zeilenschaltung (ZS") n Zeilenmodule (ZM1"...ZM4") enthält, wobei je ein Zeilenmodul einer Zeile von Speicherzellen zugeordnet ist, daß ein zweiter Ausgang eines Zeilenmoduls (ZM1") mit einem Gateanschluß jeden Auswahltransistors (ATR2...) zum Auslesen von Informationen der zugehörigen Zeile von Speicherzellen, ein erster Ausgang eines Zeilenmoduls (ZM1") mit einem Gateanschluß aller ersten der zwei in Serie geschalteten Auswahltransistoren (PTR7...) zum Einlesen von Informationen der zugehörigen Zeile von Speicherzelle verbunden ist, daß ein erster Eingang jedes Zeilenmoduls (ZM1"...ZM4") mit der Spaltenleitung zum Schreiben (SS'), ein zweiter Eingang jeden Zeilenmoduls (ZM1"...ZM4") mit der Spaltenleitung zum Lesen (SL') und ein dritter Eingang eines Zeilenmoduls (ZM1") mit der zugehörigen Zeilenadreßleitung (Zl,l') zu verschalten ist, daß eine Spaltenschaltung m Auswahlgatter (AG1"...AG4") enthält, wobei je ein Auswahlgatter einer Spalte von Speicherzellen zugeordnet ist, und ein Ausgang eines Auswahlgatters (AG4") mit einem Gateanschluß aller zweiten der zwei in Serie geschalteten Auswahltransistoren (PTR8...) zum Einlesen von Informationen der zugehörigen Zeile von Speicherzellen und mit einem zweiten Eingang der zwei pro Spalte zugeordneten Eingängen der Datenauswerteschaltung (DAS) verbunden ist, daß ein erster Eingang eines Auswahlgatters mit der Zeilenleitung (Z2'), ein zweiter Eingang eines Auswahlgatters (AG1") mit der zum Auswahlgatter zugehörigen Spaltenadreßleitung (S1,1') verschaltet ist.

14. Ein aus Speicherzellen hierarchisch aufgebauter Speicher nach Anspruch 13, **dadurch gekennzeichnet** , daß jedes Zeilenmodul (ZM1"...ZM4") zwei NOR-Gatter (NOR9, NOR10...NOR14, NOR15) enthält, und ein Ausgang des ersten NOR-Gatters (NOR9...) den ersten Ausgang, ein Ausgang des zweiten NOR-Gatters (NOR10...) den zweiten Ausgang jeweils eines Zeilenmoduls (ZM1") bildet, ein erster Eingang des ersten NOR-Gatters (NOR9) den ersten Eingang eines Zeilenmoduls (ZM1"), ein erster Eingang des zweiten NOR-Gatters (NOR10) den zweiten Eingang eines Zeilenmoduls (ZM1") darstellt und ein zweiter Eingang des ersten NOR-Gatters (NOR9) gemeinsam mit einem zweiten Eingang des zweiten NOR-Gatters (NOR10) den dritten Eingang eines Zeilenmoduls (ZM1") daß jedes Auswahlgatter (AG1"..,AG4") ein NOR-Gatter enthält, wobei ein Ausgang eines NOR-Gatters den Ausgang eines Auswahlgatters (AG1" ...AG4") und ein erster und zweiter Eingang des NOR-Gatters jeweils den ersten und zweiten Eingang eines Auswahlgatters (AG1"...AG4") bilden und daß die Zeilenadreßleitungen (Z1,1' ...Z1,4'), die Spaltenadreßleitungen (S1,1'...S1,4'), die Spaltenleitung zum Lesen (SL'), die Spaltenleitung zum Schreiben (SS'), die Zeilenleitung (Z2') und die Dateneingangsleitung (DE') mit "active low"-Signalen beschaltet sind.

15. Ein aus Speicherzellen hierarchisch aufgebauter Speicher nach Anspruch 8, **dadurch gekennzeichnet** , daß der Speichergruppe eine Spaltenleitung (S2'), eine Zeilenleitung zum Lesen (ZL'), eine Zeilenleitung zum Schreiben (ZS'), eine Dateneingangsleitung (DE') und eine Datenausgangsleitung (DA') zugeordnet ist, daß die Zeilenschaltung (ZS‴) n Zeilenmodule (ZM1‴...ZM4‴) enthält, wobei je ein Zeilenmodul einer Zeile von Speicherzellen zugeordnet ist, daß ein Ausgang eines jeden Zeilenmoduls (ZM1‴) mit einem Gateanschluß jeden ersten der zwei in Serie geschalteten Auswahltransistoren (PTR7...) zum Einlesen von Informationen der zugehörigen Zeile von Speicherzellen und mit einem Gateanschluß jeden Auswahltransistors (ATR2...) zum Auslesen von Informationen der zugehörigen Zeile von Speicherzellen verbunden ist, daß ein erster Eingang eines jeden Zeilenmoduls (ZM1‴) mit der Spaltenleitung (S2') und ein zweiter Eingang eines jeden Zeilenmoduls (ZM1‴) mit der zugehörigen Zeilenadreßleitung (Z1,1') zu verbinden ist, daß eine Spaltenschaltung (SPS‴) m Auswahlgatter (AG1‴...AG4) enthält, wobei je ein Auswahlgatter einer Spalte von Speicherzellen zugeordnet ist, daß ein erster Ausgang eines Auswahlgatters (AG4‴) mit einem Gateanschluß jeden zweiten der zwei in Serie geschalteten Auswahltransistoren (PTR8...) zum Einlesen von Informationen der zugehörigen Zeile von Speicherzellen und ein zweiter Ausgang eines Auswahlgatters mit einem zweiten Eingang der zwei pro Spalte zugeordneten Eingänge der Datenauswerteschaltung (DAS) verbunden ist, daß ein erster Eingang eines Auswahlgatters (AG1‴) mit der Zeilenleitung zum Schreiben (ZS'), ein zweiter Eingang eines Auswahlgatters mit der Zeilenleitung zum Lesen (ZL') und ein dritter Eingang mit der zugehörigen Spaltenadreßleitung (S1,1') verschaltet ist.

16. Ein aus Speicherzellen hierarchisch aufgebauter Speicher nach Anspruch 15, **dadurch gekennzeichnet** , daß jedes Zeilenmodul (ZM1‴ bis ZH4‴) ein NOR-Gatter enthält und ein Ausgang des NOR-Gatters den Ausgang eines Zeilenmoduls (ZM1‴ ...ZM4‴) und ein erster und zweiter Eingang eines NOR-Gatters den ersten und zweiten Eingang eines Zeilenmoduls (ZM1‴...ZM4‴) bildet, daß jedes Auswahlgatter (AG1‴...AG4‴) ) zwei NOR-Gatter enthält, wobei ein Ausgang des ersten NOR-Gatters (NOR16) den ersten Ausgang eines Auswahlgatters (AG1‴) und ein Ausgang des zweiten NOR-Gatters (NOR17) den zweiten Ausgang eines Auswahlgatters (AG1‴) bilden, daß ein erster Eingang eines ersten NOR-Gatters (NOR16) den ersten Eingang des Auswahlgatters (AG1‴) , ein erster Eingang des zweiten NOR-Gatters (NOR17) den zweiten Eingang eines Auswahlgatters (AG1‴) darstellt, und ein zweiter Eingang des ersten NOR-Gatters (NOR16) und ein zweiter Eingang des zweiten NOR-Gatters (NOR17) gemeinsam mit dem dritten Eingang eines Auswahlgatters (AG1‴) verschaltet ist und die Zeilenadreßleitungen (Z1,1'...Z1,4'), die Spaltenadreßleitungen (S1,1'...S1,4'), die Spaltenleitung (S2'), die Zeilenleitung zum Lesen (ZL'), die Zeilenleitung zum Schreiben (ZS') und die Dateneingangsleitung (DE') mit "active low"-Signalen beschaltet sind.

## Claims

1. A memory which is hierarchically constructed from memory cells and is divided into more than two hierarchical levels (H0, H1 ... H3), in which memory an element of the first hierarchical level (H0) is a memory cell, an element of the second hierarchical level (H1) is a group of memory cells and an element of each next-higher hierarchical level is constructed from a group of elements of the next-lower hierarchical level, in which memory each hierarchical level is assigned a column circuit and row circuit for activating, reading from and writing to the elements of the hierarchical level, characterized
- in that the row circuits (ZS1 ... ZS3) and the column circuits (SPS1 ... SPS3) on each hierarchical level are differently designed,
- in that the row circuit (ZS1) of the second hierarchical level (H1) merely comprises a first row selection circuit (ZLAS1) and the column circuit (SPS1) of the second hierarchical level (H1) merely comprises a first column selection circuit (SPAS1) and a data input and output circuit (D1I/0), the row circuit (ZS1) of the second hierarchical level (H1) consisting of row modules (ZM1 ... ZM4) which form merely from a respective row address signal (Z1,1'), dependent on a read signal (SL') and a write signal (SS'), at least one write signal (WSZ1, WSZ1') for a word or a read signal (WL1) for a word,
- in that the row circuit (ZS2) of the third hierarchical level (H2) comprises a second row selection circuit (ZLAS2) and a row preselection device (VSZ1) and the column circuit (SPS2) of the third hierarchical level (H2) comprises a second column selection circuit (SPAS2) and a column preselection device (VSS2), and a data input and output circuit (D2I/O) is provided per row,
- in that the row circuit (ZS3) of the fourth hierarchical level (H3) comprises a third row selection circuit (ZLAS3), a row amplifier (VZ3) and a row preselection device (DEVZ3), in that the row circuit (SPS3) of the fourth hierarchical level (H3) consists of a third column selection circuit (SPAS3), a column amplifier with buffer memory (VS3) and also a column decoding and preselection device (DEVS3),
- in that an address is divided in a way corresponding to the hierarchical levels into first, second and third row and column addresses (AWO-2, ABO-2; AW3-4, AB3-4; AW5-6, AB5-6),
- in that on the fourth hierarchical level (H3) the third row and column selection circuits (ZLAS3, SPAS3) select on the basis of the third row and column addresses (AW5-6, AB5-6) an element (1K) of the third hierarchical level (H2), the amplifiers (VZ3, VS3) amplify the second row and column addresses (AW3-4, AB3-4), the decoding devices (DEVZ3, DEVS3) decode the first row and column addresses (AW0-2, AB0-2), and the preselection devices (DEVZ3, DEVS3) preselect the decoded first row and column addresses on the basis of the element selection made,
- in that on the third hierarchical level (H2) the second row and column selection circuits (ZLAS2, SPAS2) select on the basis of the second row and column addresses (AW3-4, AB3-4) an element (64) of the second hierarchical level (H1), and the preselection devices (VSZ2, VSS2) preselect the decoded first row and column addresses (AB0-2, AW0-2) on the basis of the element selection made, and
- in that on the second hierarchical level (H1) the first row and column selection circuits (ZLAS1, SPAS1) select on the basis of the decoded first row and column addresses (AW0-2, AB0-2) an element of the first hierarchical level (H0).

2. A memory hierarchically constructed from memory cells according to Claim 1, characterized in that the memory cells are static memory cells and in that each memory cell is equipped with a data line for reading in information (DS1...DS4) into the memory cell and with a data line for reading out information (DL1...DL4) from the memory cell.

3. A memory hierarchically constructed from memory cells according to Claim 1 or 2, characterized in that decoder circuits for column-address and row-address lines in the column and row circuit of the lower hierarchical level (H2) are realized on a higher or highest hierarchical level (H3).

4. A memory hierarchically constructed from memory cells according to Claim 3, characterized in that the second hierarchical level is constructed in rows and columns from a memory group having n·m memory cells (n, m = an integer) and n row-address lines and m column-address lines are assigned to the memory group, in that a column circuit (SPS) of the second hierarchical level includes a data evaluation circuit (DAS), the latter having per column two inputs and a common output (ADA), of which in each case a first input is connected to a data line for reading out information (DL1 ... DL4) from the memory cells of the column, and in each case a second input is connected to a control terminal (SA1 ... SA) of the column selection circuit (SPAS) and in this way one of the data lines (DL1 ... DL4) is selected, in that the two inputs per column are linked to each other via NAND-NOR gates (NANDNOR1, NANDNOR2) and the outputs of the NAND-NOR gates (NANDNOR1, NANDNOR2) are connected via NAND gates (NAND1) to the common output (ADA) of the data evaluation circuit (DAS).

5. A memory hierarchically constructed from memory cells according to Claim 4, characterized in that the NAND gate (NAND1) having two inputs and one output includes two field-effect transistors of the first conductivity type (NTR1, NTR2) and two field-effect transistors of the second conductivity type (PTR1, PTR2), in that the field-effect transistors of the first conductivity type (NTR1, NTR2) are connected in series, a first terminal of the first field-effect transistor of the first conductivity type (NTR1) being connected to the supply voltage (VDD) and a first terminal of the second field-effect transistor of the first conductivity type (NTR2) forming the output of the NAND gate (NAND1), in that a gate terminal of the first field-effect transistor of the first conductivity type (NTR1) and a gate terminal of the first field-effect transistor of the second conductivity type (PTR1) jointly represent the first input of the NAND gate (NAND1) and a gate terminal of the second field-effect transistor of the first conductivity type (NTR2) and a gate terminal of the second field-effect transistor of the second conductivity type (PTR2) jointly represent the second input of the NAND gate (NAND1), in that the first and the second field-effect transistor of the second conductivity type (PTR1, PTR2) are connected in parallel between a reference potential (VSS) and the first terminal of the second field-effect transistor of the first conductivity type (NTR2).

6. A memory hierarchically constructed from memory cells according to Claim 4, characterized in that the NAND-NOR gate (NANDNOR1; NANDNOR2) includes four inputs and an output, a field-effect transistor of the first conductivity type (NTR3; NTR3') and four field-effect transistors of the second conductivity type (PTR3, PTR4, PTR5, PTR6; PTR3', PTR4', PTR5', PTR6'), in that every two of the four field-effect transistors of the second conductivity type (PTR3, PTR4; PTR5, PTR6; PTR3', PTR4'; PTR5', PTR6') are connected in series and form a first and a second series connection, in that the first and the second series connections are connected in parallel between a reference potential (VSS) and a common connection point (AP, AP'), in that the field-effect transistor of the first conductivity type (NTR3; NTR3') is arranged between the supply voltage (VDD) and the common connection point (AP, AP'), and the common connection point (AP, AP') forms the output of the NAND-NOR gate, in that a gate terminal of the field-effect transistor of the first conductivity type (NTR3; NTR3') is connected to the reference potential (VSS) and gate terminals of the field-effect transistors of the first series connection and gate terminals of the field-effect transistors of the second series connection each form in pairs inputs of the NAND-NOR gate (NANDNOR1, NANDNOR2), which are to be connected to the two inputs per column of the data evaluation circuit (DAS).

7. A memory hierarchically constructed from memory cells according to one of Claims 3 to 6, characterized in that each memory cell of the memory group includes a transfer gate (TG), two inverters (I1, I2) and a selection transistor (ATR1), in that the transfer gate (TG) is connected between the data line belonging to the column of the memory cell for reading in the information (DS1...DS4) and an input of the first inverter (I1), in that the second inverter (I2) is coupled back to the first inverter (I1) and the selection transistor (ATR1) is connected between an output of the first inverter (I1) and the data line belonging to the column of the memory cell for reading out information (DL1...DL4).

8. A memory hierarchically constructed from memory cells according to one of Claims 3 to 6, characterized in that each memory cell of the memory group includes two series-connected selection transistors (PTR7, PTR8) for reading in information into the memory cell, two inverters (I3, I4) and a selection transistor (ATR2) for reading out information from the memory cell, in that the two series-connected selection transistors (PTR7, PTR8) are connected between the data line belonging to the column of the memory cell for reading in the information (DS1... DS4) and an input of the first inverter (I3), in that the second inverter (I4) is coupled back to the first inverter (I3) and the selection transistor (ATR2) is connected between an output of the first inverter (I3) and the data line belonging to the column of the memory cell for reading out information (DL1...DL4).

9. A memory hierarchically constructed from memory cells according to Claim 7, characterized in that a column line for reading (SL'), a column line for writing (SS'), a row line (Z2'), a data input line (DE') and a data output line (DA') are assigned to the memory group, in that the row circuit (ZS) includes n row modules (ZM1 ...ZM4), one row module being assigned in each case to a row of memory cells, in that a first and a second output of each row module (ZM1...ZM4) is connected to a first and a second control input of all the transfer gates (TG) in the associated row of memory cells and a third output is connected to a gate terminal of all the selection transistors (ATR1) in the associated row of memory cells, in that a first input of each row module (ZM1...ZM4) is to be connected to the column line for reading (SL'), a second input of each row module (ZM1...ZM4) is to be connected to the column line for writing (SS') and a third input of each row module (ZM1...ZM4) is to be connected to the associated row-address line (Z1,1'... Z4,4'), in that the column circuit (SPS) includes m transfer gates (TG1...TG4) and m selection gates (AG1... AG4), one transfer gate and one selection gate being assigned in each case to a column of memory cells, in that each transfer gate (TG1...TG4) is connected between the data input line (DE') and the data line belonging to the column for reading in information (DS1...DS4), in that each transfer gate is assigned to a common control terminal (SA1...SA4), which is connected on the one hand directly to a first control input and via an inverter (I5...I8) to a second control input of the associated transfer gate (TG1...TG4) and which on the other hand is connected to an output of the associated selection gate (AG1...AG4) and to one of the two inputs of the data evaluation circuit (DAS) assigned per column and in that each selection gate (AG1...AG4) is to be connected by a first terminal to the row line (Z2') and by a second terminal to the associated column-address line (S1,1'... S1,4').

10. A memory hierarchically constructed from memory cells according to Claim 9, characterized in that each row module (ZM1...ZM4) includes two NOR gates (NOR1, NOR2;...; NOR7, NOR8) and an inverter (I9...I12), in that a first terminal of the first NOR gate forms the first terminal of a row module (ZM1), a first terminal of the second NOR gate (NOR2) forms the second terminal of a row module (ZM1) and a second terminal of the first NOR gate (NOR1) and a second terminal of the second NOR gate (NOR2) jointly form the third input of a row module (ZM1), in that an output of the first NOR gate (NOR1) represents the first output and, via a further inverter (I9), the second output of in each case one row module (ZM1) and an output of the second NOR gate (NOR2) forms the third output of a row module (ZM1), in that each selection gate (AG1...AG4) is constructed with the aid of in each case one NOR gate (NOR9...NOR12), an output of an NOR gate (NOR9...NOR12) representing the output of a selection gate (AG1...AG4) and a first and a second input of an NOR gate (NOR9...NOR12) representing the first and the second input of a selection gate (AG1...AG4), and in that the row-address lines (Z1,1'...Z1,4'), the column-address lines (S1,1'...S1,4'), the column line for reading (SL'), the column line for writing (SS'), the row line (Z2') and the data output line (DE') are connected to "active low" signals.

11. A memory hierarchically constructed from memory cells according to Claim 9, characterized in that each row module (ZM1'...ZM4') includes two field-effect transistors of the first conductivity type (NTR4, NTR5) and four field-effect transistors of the second conductivity type (PTR9... PTR12) and an inverter (I13), in that the first field-effect transistor of the first conductivity type (NTR5) is connected in series to the first field-effect transistor of the second conductivity type (PTR11) and the second field-effect transistor of the first conductivity type (NTR4) is connected in series to the second field-effect transistor of the second conductivity type (PTR9), a first terminal of the first field-effect transistor of the first conductivity type (NTR5) forming jointly with a gate terminal of the third field-effect transistor of the second conductivity type (PTR10) the first input of a row module (ZM1'), a first terminal of the second field-effect transistor of the first conductivity type (NTR4) forming jointly with a gate terminal of the fourth field-effect transistor of the second conductivity type (PTR12) the second input of a row module and a gate terminal of the first field-effect transistor of the first conductivity type (NTR5), a gate terminal of the first field-effect transistor of the second conductivity type (PTR11), a gate terminal of the second field-effect transistor of the first conductivity type (NTR4) and a gate terminal of the second field-effect transistor of the second conductivity type (PTR9) jointly forming the third input of a row module, in that a first terminal of the first field-effect transistor of the second conductivity type (PTR11) and a first terminal of the second field-effect transistor of the second conductivity type (PTR9) are jointly connected to a reference potential (VSS), in that a second terminal of the first field-effect transistor of the first conductivity type (NTR5) and a second terminal of the first field-effect transistor of the second conductivity type (PTR11) jointly form the third output of a row module (ZM1'), the third field-effect transistor of the second conductivity type (PTR12) being connected between the latter and the reference potential (VSS), in that a second terminal of the second field-effect transistor of the first conductivity type (NTR4) and a second terminal of the second field-effect transistor of the second conductivity type (PTR9) jointly represent the first output of a row module (ZM1') and, via a further inverter (I13) the second output of a row module (ZM1'), the first output of a row module being connected via the fourth field-effect transistor of the second conductivity type (PTR10) to the reference potential (VSS), in that each selection gate (AG1'...AG4') includes a field-effect transistor of the first conductivity type (NTR6) and two field-effect transistors of the second conductivity type (PTR13, PTR14), the first field-effect transistor of the first conductivity type (NTR6) and the first field-effect transistor of the second conductivity type (PTR13) being connected in series between the row line (Z2) and the reference potential (VSS), in that a gate terminal of the first field-effect transistor of the first conductivity type (NTR6) and a gate terminal of the first field-effect transistor of the second conductivity type (PTR13) are jointly connected to an associated column-address line (S1,1') and a second terminal of the first field-effect transistor of the first conductivity type (NTR6) and a second terminal of the first field-effect transistor of the second conductivity type (PTR13) represent the output of a selection gate (AG1'), the latter being connected via a second field-effect transistor of the second conductivity type (PTR14) to the reference potential (VSS) and a gate terminal of the second field-effect transistor of the second conductivity type (PTR14...) of each selection gate (AG1'...AG4') being connected via an inverter (I14) to the row line (Z2), in that the row-address lines (Z1,1'...Z1,4'), the column-address lines (S1,1...S1,4'), and also the data input line (DE') are connected to "active low" signals and the row line (Z2), the column line for writing (SS) and the column line for reading (SL) are connected to "active high" signals.

12. A memory hierarchically constructed from memory cells according to one of the preceding claims, characterized in that a transfer gate is constructed from a field-effect transistor of the first conductivity type and a field-effect transistor of the second conductivity type, in that the field-effect transistor of the first conductivity type is connected in parallel to the field-effect transistor of the second conductivity type and a gate terminal of the field-effect transistor of the second conductivity type forms the second control input and a gate terminal of the field-effect transistor of the first conductivity type forms the first control input of a transfer gate.

13. A memory hierarchically constructed from memory cells according to Claim 8, characterized in that the memory group is assigned a column line for reading (SL'), a column line for writing (SS'), a row line (Z2'), a data input line (DE') and a data output line (DA'), in that the row circuit (ZS") includes n row modules (ZM1"... ZM4"), one row module being assigned in each case to a row of memory cells, in that a second output of a row module (ZM1") is connected to a gate terminal of each selection transistor (ATR2...) for reading out information of the associated row of memory cells, a first output of a row module (ZM1") is connected to a gate terminal of all the first transistors of the two series-connected selection transistors (PTR7...) for reading in information of the associated row of memory cells, in that a first input of each row module (ZM1"...ZM4") is to be connected to the column line for writing (SS'), a second input of each row module (ZM1"...ZM4") is to be connected to the column line for reading (SL') and a third input of the row module (ZM1") is to be connected to the associated row-address line (Z1,1'), in that a column circuit includes m selection gates (AG1"... AG4"), one selection gate being assigned in each case to a column of memory cells, and an output of a selection gate (AG4") is connected to a gate terminal of all the second transistors of the two series-connected selection transistors (PTR8...) for reading in information of the associated row of memory cells and to a second input of the two inputs of the data evaluation circuit (DAS) assigned per column, in that a first input of a selection gate is connected to the row line (Z2'), and a second input of the selection gate (AG1") is connected to the column-address line (S1,1') associated with the selection gate.

14. A memory hierarchically constructed from memory cells according to Claim 13, characterized in that each row module (ZM1"...ZM4") includes two NOR gates (NOR9, NOR10...NOR14, NOR15), and an output of the first NOR gate (NOR9...) forms the first output, an output of the second NOR gate (NOR10...) forms the second output in each case of a row module (ZM1"), a first input of the first NOR gate (NOR9) represents the first input of a row module (ZM1"), a first input of the second NOR gate (NOR10) represents the second input of a row module (ZM1") and a second input of the first NOR gate (NOR9) forms jointly with a second input of the second NOR gate (NOR10) the third input of a row module (ZM1"), in that each selection gate (AG1"...AG4") includes an NOR gate, an output of an NOR gate forming the output of a selection gate (AG1"...AG4") and a first and a second input of the NOR gate respectively forming the first and the second input of a selection gate (AG1"...AG4") and in that the row-address lines (Z1,1'...Z1,4'), the column-address lines (S1,1'...S1,4'), the column line for reading (SL'), the column line for writing (SS'), the row line (Z2') and the data input line (DE') are connected to "active low" signals.

15. A memory hierarchically constructed from memory cells according to Claim 8, characterized in that the memory group is assigned a column line (S2'), a row line for reading (ZL'), a row line for writing (ZS'), a data input line (DE') and a data output line (DA'), in that the row circuit (ZS‴) includes n row modules (ZM1‴ ...ZM4‴), one row module being assigned in each case to a row of memory cells, in that an output of each row module (ZM1‴) is connected to a gate terminal of each first transistor of the two series-connected selection transistors (PTR7...) for reading in information of the associated row of memory cells and to a gate terminal of each selection transistor (ATR2...) for reading out information of the associated row of memory cells, in that a first input of each row module (ZM1‴) is to be connected to the column line (S2') and a second input of each row module (ZM1‴) is to be connected to the associated row-address line (Z1,1'), in that a column circuit (SPS‴) includes m selection gates (AG1‴... AG4‴), one selection gate being assigned in each case to a column of memory cells, in that a first output of a selection gate (AG4‴) is connected to a gate terminal of each second transistor of the two series-connected selection transistors (PTR8...) for reading in information of the associated row of memory cells and a second output of a selection gate is connected to a second input of the two inputs of the data evaluation circuit (DAS) per column, in that a first input of a selection gate (AG1‴) is connected to the row line for writing (ZS'), a second input of a selection gate is connected to the row line for reading (ZL') and a third input is connected to the associated column-address line (S1,1').

16. A memory hierarchically constructed from memory cells according to Claim 15, characterized in that each row module (ZM1‴ to ZM4‴) includes an NOR gate and an output of the NOR gate forms the output of a row module (ZM1‴...ZM4‴) and a first and a second input of an NOR gate form the first and the second input of a row module (ZM1‴...ZM4‴), in that each selection gate (AG1‴...AG4‴) includes two NOR gates, an output of the first NOR gate (NOR16) forming the first output of a selection gate (AG1‴) and an output of the second NOR gate (NOR17) forming the second output of a selection gate (AG1‴), in that a first input of a first NOR gate (NOR16) represents the first input of the selection gate (AG1‴), a first input of a second NOR gate (NOR17) represents the second input of the selection gate (AG1‴), and a second input of the first NOR gate (NOR16) and a second input of the second NOR gate (NOR17) are jointly connected to the third input of a selection gate (AG1‴) and the row-address lines (Z1,1'...Z1,4'), the column-address lines (S1,1'...S1,4'), the column line (S2'), the row line for reading (ZL'), the row line for writing (ZS') and the data input line (DE') are connected to "active low" signals.

## Revendications

1. Mémoire composée hiérarchiquement de cellules de mémoire, qui est divisée en plus de deux niveaux hiérarchiques (H0, H1 ... H3), selon laquelle un élément du premier niveau hiérarchique (H0) est une cellule de mémoire, un élément du deuxième niveau hiérarchique (H1) est un groupe de cellules de mémoire et un élément de chaque niveau hiérarchique immédiatement supérieur est composé d'un groupe d'éléments du niveau hiérarchique immédiatement inférieur, selon laquelle est attribué à chaque niveau hiérarchique un circuit de colonne et de ligne destiné à la sélection, à la lecture et à l'écriture des éléments du niveau hiérarchique, caractérisée en ce que
- les circuits de ligne (ZS1 ... ZS3) et les circuits de colonne (SPS1 ... SPS3) se présentent à chaque niveau hiérarchique sous une forme différente ;
- le circuit de ligne (ZS1) du deuxième niveau hiérarchique (H1) se compose uniquement d'un premier circuit de sélection de ligne (ZLAS1) et le circuit de colonne (SPS1) du deuxième niveau hiérarchique (H1) uniquement d'un premier circuit de sélection de colonne (SPAS1 ) et d'un circuit d'entrée et de sortie de données (D1I/0), le circuit de ligne (ZS1) du deuxième niveau hiérarchique (H1) se composant de modules de ligne (ZM1 ... ZM4), lesquels forment, uniquement à partir d'un signal d'adresse de ligne (Z1,1') respectif, dépendant d'un signal de lecture (SL') et d'un signal d'écriture (SS'), au moins un signal d'écriture de mot (WSZ1, WSZ1') ou un signal de lecture de mot (WL1) ;
- le circuit de ligne (ZS2) du troisième niveau hiérarchique (H2) se compose d'un deuxième circuit de sélection de ligne (ZLAS2) et d'un dispositif de présélection de ligne (VSZ2) et le circuit de colonne (SPS2) du troisième niveau hiérarchique (H2) d'un deuxième circuit de sélection de colonne (SPAS2) et d'un dispositif de présélection de colonne (VSS2), et un circuit d'entrée et de sortie de données (D2I/0) par ligne est prévu ;
- le circuit de ligne (ZS3) du quatrième niveau hiérarchique (H3) se compose d'un troisième circuit de sélection de ligne (ZLAS3), d'un amplificateur de ligne (VZ3) et d'un dispositif de présélection de ligne (DEVZ3), en ce que le circuit de colonne (SPS3) du quatrième niveau hiérarchique (H3) se compose d'un troisième circuit de sélection de colonne (SPAS3), d'un amplificateur de colonne avec une mémoire intermédiaire (VS3) et d'un dispositif de décodage et de présélection de colonne (DEVS3) ;
- une adresse est divisée selon les niveaux hiérarchiques en premières, deuxièmes et troisièmes adresses de ligne et de colonne (AW0-2, AB0-2 ; AW3-4, AB3-4 ; AW5-6, AB5-6) ;
- au quatrième niveau hiérarchique (H3), les troisièmes circuits de sélection de ligne et de colonne (ZLAS3, SPAS3) sélectionnent à l'aide des troisièmes adresses de ligne et de colonne (AW5-6, AB5-6) un élément (1K) du troisième niveau hiérarchique (H2), les amplificateurs (VZ3, VS3) amplifient les deuxièmes adresses de ligne et de colonne (AW3-4, AB3-4), les dispositifs de décodage (DEVZ3, DEVS3) décodent les premières adresses de ligne et de colonne (AW0-2, AB0-2) et les dispositifs de présélection (DEVZ3, DEVS3) présélectionnent les premières adresses de ligne et de colonne décodées à l'aide de l'élément sélectionné ;
- au troisième niveau hiérarchique (H2), les deuxièmes circuits de sélection de ligne et de colonne (ZLAS2, SPAS2) sélectionnent à l'aide des deuxièmes adresses de ligne et de colonne (AW3-4, AB3-4) un élément (64) du deuxième niveau hiérarchique (H1), et les dispositifs de présélection (VSZ2, VSS2) présélectionnent les premières adresses de ligne et de colonne (AB0-2, AW0-2) décodées à l'aide de l'élément sélectionné, et
- au deuxième niveau hiérarchique (H1), les premiers circuits de sélection de ligne et de colonne (ZLAS1, SPAS1) sélectionnent à l'aide des premières adresses de ligne et de colonne (AW0-2, AB0-2) décodées un élément du premier niveau hiérarchique (H0).

2. Mémoire composée hiérarchiquement de cellules de mémoire selon la revendication 1, caractérisée en ce que les cellules de mémoire sont des cellules de mémoire statiques et en ce que chaque cellule de mémoire est équipée d'une ligne de données d'entrée d'informations (DS1...DS4) dans la cellule de mémoire et d'une ligne de données de sortie d'informations (DL1...DL4) de la cellule de mémoire.

3. Mémoire composée hiérarchiquement de cellules de mémoire selon la revendication 1 ou 2, caractérisée en ce que des circuits de décodage pour des lignes d'adresse de colonne et de ligne dans le circuit de colonne et de ligne du niveau hiérarchique inférieur (H2) sont réalisés à un niveau hiérarchique supérieur ou maximal (H3).

4. Mémoire composée hiérarchiquement de cellules de mémoire selon la revendication 3, caractérisée en ce que le deuxième niveau hiérarchique, composé d'un groupe de mémoire avec n,m cellules de mémoire (n, m = nombre entier), est divisé en lignes et en colonnes, et n lignes d'adresse de ligne et m lignes d'adresse de colonne sont attribuées au groupe de mémoire, en ce qu'un circuit de colonne (SPS) du deuxième niveau hiérarchique comporte un circuit d'exploitation de données (DAS), ce dernier présentant par colonne deux entrées et une sortie commune (ADA), dont une première entrée est chaque fois reliée à une ligne de données de sortie d'informations (DL1 ... DL4) des cellules de mémoire d'une colonne et une deuxième entrée est reliée à une borne de commande (SA1 ...SA) du circuit de sélection de colonne (SPAS) et l'une des lignes de données (DL1 ...DL4) est ainsi sélectionnée, et en ce que les deux entrées par colonne sont interconnectées par l'intermédiaire de grilles NON-ET/NON-OU (NANDNOR1, NANDNOR2) et les sorties des grilles NON-ET/NON-OU (NANDNOR1, NANDNOR2) sont connectées, par l'intermédiaire de grilles NON-ET (NAND1), à la sortie commune (ADA) du circuit d'exploitation de données (DAS).

5. Mémoire composée hiérarchiquement de cellules de mémoire selon la revendication 4, caractérisée en ce que la grille NON-ET (NAND1) à deux entrées et une sortie comporte deux transistors à effet de champ du premier type de ligne (NTR1, NTR2) et deux transistors à effet de champ du deuxième type de ligne (PTR1, PTR2), en ce que les transistors à effet de champ du premier type de ligne (NTR1, NTR2) sont montés en série, une première borne du premier transistor à effet de champ du premier type de ligne (NTR1) étant reliée à la tension d'alimentation (VDD) et une première borne du deuxième transistor à effet de champ du premier type de ligne (NTR2) formant la sortie de la grille NON-ET (NAND1), en ce qu'une borne de grille du premier transistor à effet de champ du premier type de ligne (NTR1) et une borne de grille du premier transistor à effet de champ du deuxième type de ligne (PTR1) constituent ensemble la première entrée de la grille NON-ET (NAND1), et une borne de grille du deuxième transistor à effet de champ du premier type de ligne (NTR2) et une borne de grille du deuxième transistor à effet de champ du deuxième type de ligne (PTR2) constituent ensemble la deuxième entrée de la grille NON-ET (NAND1), en ce que le premier et le deuxième transistor à effet de champ du deuxième type de ligne (PTR1, PTR2) sont montés en parallèle entre un potentiel de référence (VSS) et la première borne du deuxième transistor à effet de champ du premier type de ligne (NTR2).

6. Mémoire composée hiérarchiquement de cellules de mémoire selon la revendication 4, caractérisée en ce que la grille NON-ET/NON-OU (NANDNOR1 ; NANDNOR2) à quatre entrées et une sortie comporte un transistor à effet de champ du premier type de ligne (NTR3 ; NTR3') et quatre transistors à effet de champ du deuxième type de ligne (PTR3, PTR4, PTR5, PTR6 ; PTR3', PTR4', PTR5', PTR6'), en ce que chaque fois deux des quatre transistors à effet de champ du deuxième type de ligne (PTR3, PTR4, PTR5, PTR6 ; PTR3', PTR4', PTR5', PTR6') sont montés en série et forment un premier et un deuxième montage en série, en ce que le premier et le deuxième montage en série sont câblés en parallèle entre un potentiel de référence (VSS) et un point de connexion commun (AP, AP'), en ce que le transistor à effet de champ du premier type de ligne (NTR3 ; NTR3') est disposé entre la tension d'alimentation (VDD) et le point de connexion commun (AP, AP') et le point de connexion commun (AP, AP') forme la sortie de la grille NON-ET/NON-OU, en ce qu'une borne de grille du transistor à effet de champ du premier type de ligne (NTR3 ; NTR3') est reliée au potentiel de référence (VSS) et des bornes de grille des transistors à effet de champ du premier montage en série et des bornes de grille des transistors à effet de champ du deuxième montage en série forment chaque fois par paire des entrées de la grille NON-ET/NON-OU (NANDNOR1, NANDNOR2), lesquelles doivent être câblées avec les deux entrées par colonne du circuit d'exploitation de données (DAS).

7. Mémoire composée hiérarchiquement de cellules de mémoire selon l'une des revendications 3 à 6, caractérisée en ce que chaque cellule de mémoire du groupe de mémoire comporte une grille de transfert (TG), deux inverseurs (I1, I2) et un transistor de sélection (ATR1), en ce que la grille de transfert (TG) est montée entre la ligne de données d'entrée d'informations (DS1... DS4) associée à la colonne de la cellule de mémoire et une entrée du premier inverseur (I1), en ce que le deuxième inverseur (I2) est couplé rétroactivement au premier inverseur (I1) et le transistor de sélection (ATR1) est monté entre une sortie du premier inverseur (I1) et la ligne de données de sortie d'informations (DL1...DL4) associée à la colonne de la cellule de mémoire.

8. Mémoire composée hiérarchiquement de cellules de mémoire selon l'une des revendications 3 à 6, caractérisée en ce que chaque cellule de mémoire du groupe de mémoire comporte deux transistors de sélection (PTR7, PTR8) montés en série, destinés à entrer des informations dans la cellule de mémoire, deux inverseurs (I3, I4) et un transistor de sélection (ATR2) destiné à sortir des informations de la cellule de mémoire, en ce que les deux transistors de sélection (PTR7, PTR8) montés en série sont montés entre la ligne de données d'entrée d'informations (DS1... DS4) associée à la colonne de la cellule de mémoire et une entrée du premier inverseur (I3), en ce que le deuxième inverseur (I4) est couplé rétroactivement au premier inverseur (I3) et le transistor de sélection (ATR2) est monté entre une sortie du premier inverseur (13) et la ligne de données de sortie d'informations (DL1... DL4) associée à la colonne de la cellule de mémoire.

9. Mémoire composée hiérarchiquement de cellules de mémoire selon la revendication 7, caractérisée en ce qu'une ligne de colonne de lecture (SL'), une ligne de colonne d'écriture (SS'), un circuit de ligne (Z2'), une ligne d'entrée de données (DE') et une ligne de sortie de données (DA') sont attribués au groupe de mémoire, en ce que le circuit de ligne (ZS) comporte n modules de ligne (ZM1... ZM4), respectivement un module de ligne étant attribué à une ligne de cellules de mémoire, en ce qu'une première et une deuxième sortie de chaque module de ligne (ZM1...ZM4) sont câblées avec une première et une deuxième entrée de commande de toutes les grilles de transfert (TG) dans la ligne de cellules de mémoire associée, et une troisième sortie est connectée à une borne de grille de tous les transistors de sélection (ATR1) dans la ligne de cellules de mémoire associée, en ce qu'une première entrée de chaque module de ligne (ZM1...ZM4) doit être câblée avec la ligne de colonne de lecture (SL'), une deuxième entrée de chaque module de ligne (ZM1...ZM4) avec la ligne de colonne d'écriture (SS') et une troisième entrée de chaque module de ligne (ZM1...ZM4) avec le circuit d'adresse de ligne associé (Z1,1'...Z4,4'), en ce que le circuit de colonne (SPS) comporte m grilles de transfert (TG1...TG4) et m grilles de sélection (AG1...AG4), respectivement une grille de transfert et respectivement une grille de sélection étant attribuée à une colonne de cellules de mémoire, en ce que chaque grille de transfert (TG1...TG4) est montée entre la ligne d'entrée d'informations (DE') et la ligne de données d'entrée d'informations (DS1...DS4) associée à la colonne, en ce que chaque grille de transfert est attribuée à une borne de commande commune (SA1...SA4), qui est câblée d'une part directement avec une première entrée de commande et, par l'intermédiaire d'un inverseur (I5...I8), avec une deuxième entrée de commande de la grille de transfert (TG1...TG4) associée, et qui est connectée d'autre part à une sortie de la grille de sélection (AG1...AG4) associée et à l'une des deux entrées par colonne du circuit d'exploitation de données (DAS) et en ce que chaque grille de sélection (AG1...AG4) doit être connectée avec une première borne au circuit de ligne (Z2') et avec une deuxième borne à la ligne d'adresse de colonne (S1,1'...S1,4') associée.

10. Mémoire composée hiérarchiquement de cellules de mémoire selon la revendication 9, caractérisée en ce que chaque module de ligne (ZM1...ZM4) comporte deux grilles NON-OU (NOR1, NOR2 ; ... ; NOR7, NOR8) et un inverseur (I9...I12), en ce qu'une première borne de la première grille NON-OU forme la première borne d'un module de ligne (ZM1), une première borne de la deuxième grille NON-OU (NOR2) forme la deuxième borne d'un module de ligne (ZM1) et une deuxième borne de la première et une deuxième borne de la deuxième grille NON-OU (NOR1, NOR2) forment ensemble la troisième entrée d'un module de ligne (ZM1), en ce qu'une sortie de la première grille NON-OU (NOR1) constitue la première sortie et, par l'intermédiaire d'un autre inverseur (I9), la deuxième sortie de respectivement un module de ligne (ZM1) et une sortie de la deuxième grille NON-OU (NOR2) forme la troisième sortie d'un module de ligne (ZM1), en ce que chaque grille de sélection (AG1...AG4) est composée à l'aide de respectivement une grille NON-OU (NOR9...NOR12), une sortie d'une grille NON-OU (NOR9...NOR12) constituant la sortie d'une grille de sélection (AG1...AG4) et une première et une deuxième entrée d'une grille NON-OU (NOR9...NOR12) la première et la deuxième entrée d'une grille de sélection (AG1...AG4), et en ce que des signaux "active low" sont appliqués aux circuits d'adresse de ligne (Z1,1'...Z1,4'), aux circuits d'adresse de colonne (S1,1'...S1,4'), à la ligne de colonne de lecture (SL'), à la ligne de colonne d'écriture (SS'), au circuit de ligne (Z2') et à la ligne de sortie de données (DE').

11. Mémoire composée hiérarchiquement de cellules de mémoire selon la revendication 9, caractérisée en ce que chaque module de ligne (ZM1'...ZM4') comporte deux transistors à effet de champ du premier type de ligne (NTR4, NTR5) et quatre transistors à effet de champ du deuxième type de ligne (PTR 9...PTR12) et un inverseur (I13), en ce que le premier transistor à effet de champ du premier type de ligne (NTR5) est monté en série avec le premier transistor à effet de champ du deuxième type de ligne (PTR11) et le deuxième transistor à effet de champ du premier type de ligne (NTR4) avec le deuxième transistor à effet de champ du deuxième type de ligne (PTR9), une première borne du premier transistor à effet de champ du premier type de ligne (NTR5) formant ensemble avec une borne de grille du troisième transistor à effet de champ du deuxième type de ligne (PTR10) la première entrée d'un module de ligne (ZM1'), une première borne du deuxième transistor à effet de champ du premier type de ligne (NTR4) formant ensemble avec une borne de grille du quatrième transistor à effet de champ du deuxième type de ligne (PTR12) la deuxième entrée d'un module de ligne, et une borne de grille du premier transistor à effet de champ du premier type de ligne (NTR5), une borne de grille du premier transistor à effet de champ du deuxième type de ligne (PTR11), une borne de grille du deuxième transistor à effet de champ du premier type de ligne (NTR4) et une borne de grille du deuxième transistor à effet de champ du deuxième type de ligne (PTR9) formant ensemble la troisième entrée d'un module de ligne, en ce qu'une première borne du premier transistor à effet de champ du deuxième type de ligne (PTR11) et une première borne du deuxième transistor à effet de champ du deuxième type de ligne (PTR9) sont câblées ensemble avec un potentiel de référence (VSS), en ce qu'une deuxième borne du premier transistor à effet de champ du premier type de ligne (NTR5) et une deuxième borne du premier transistor à effet de champ du deuxième type de ligne (PTR11) forment ensemble la troisième sortie d'un module de ligne (ZM1'), entre celles-ci et le potentiel de référence (VSS) étant câblé le troisième transistor à effet de champ du deuxième type de ligne (PTR12), en ce qu'une deuxième borne du deuxième transistor à effet de champ du premier type de ligne (NTR4) et une deuxième borne du deuxième transistor à effet de champ du deuxième type de ligne (PTR12) constituent ensemble la première sortie d'un module de ligne (ZM1') et, par l'intermédiaire d'un autre inverseur (I13), la deuxième sortie d'un module de ligne (ZM1'), la première sortie d'un module de ligne étant câblée, par l'intermédiaire du quatrième transistor à effet de champ du deuxième type de ligne (PTR10), avec le potentiel de référence (VSS), en ce que chaque grille de sélection (AG1'...AG4') comporte un transistor à effet de champ du premier type de ligne (NTR6) et deux transistors à effet de champ du deuxième type de ligne (PTR13, PTR14), le premier transistor à effet de champ du premier type de ligne (NTR6) et le premier transistor à effet de champ du deuxième type de ligne (PTR13) étant montés en série entre le circuit de ligne (Z2) et le potentiel de référence (VSS), en ce qu'une borne de grille du premier transistor à effet de champ du premier type de ligne (NTR6) et une borne de grille du premier transistor à effet de champ du deuxième type de ligne (PTR13) sont câblées ensemble avec une ligne d'adresse de colonne (S1,1') associée, et une deuxième borne du premier transistor à effet de champ du premier type de ligne (NTR6) et une deuxième borne du premier transistor à effet de champ du deuxième type de ligne (PTR13) constituent la sortie d'une grille de sélection (AG1'), celle-ci étant câblée, par l'intermédiaire d'un deuxième transistor à effet de champ du deuxième type de ligne (PTR14), avec le potentiel de référence (VSS), et une borne de grille du deuxième transistor à effet de champ du deuxième type de ligne (PTR14...) de chaque grille de sélection (AG1'...AG4') est connectée, par l'intermédiaire d'un inverseur (I14), au circuit de ligne (Z2), en ce que des signaux "active low" sont appliqués aux circuits d'adresse de ligne (Z1,1'...Z1,4'), aux circuits d'adresse de colonne (S1,1'...S1,4') et à la ligne d'entrée de données (DE') et des signaux "active high" au circuit de ligne (Z2), à la ligne de colonne d'écriture (SS) et à la ligne de colonne de lecture (SL).

12. Mémoire composée hiérarchiquement de cellules de mémoire selon l'une des revendications précédentes, caractérisée en ce qu'une grille de transfert est composée d'un transistor à effet de champ du premier type de ligne et d'un transistor à effet de champ du deuxième type de ligne, en ce que le premier transistor à effet de champ du premier type de ligne est câblé en parallèle avec le transistor à effet de champ du deuxième type de ligne et une borne de grille du transistor à effet de champ du deuxième type de ligne forme la deuxième borne de commande et une borne de grille du transistor à effet de champ du premier type de ligne la première borne de commande d'une grille de transfert.

13. Mémoire composée hiérarchiquement de cellules de mémoire selon la revendication 8, caractérisée en ce qu'une ligne de colonne de lecture (SL'), une ligne de colonne d'écriture (SS'), un circuit de ligne (Z2'), une ligne d'entrée de données (DE') et une ligne de sortie de données (DA') sont attribués au groupe de mémoire, en ce que le circuit de ligne (ZS") comporte n modules de ligne (ZM1"...ZM4"), respectivement un module de ligne étant attribué à une ligne de cellules de mémoire, en ce qu'une deuxième sortie d'un module de ligne (ZM1") est reliée à une borne de grille de chaque transistor de sélection (ATR2...) destiné à sortir des informations de la ligne de cellules de mémoire associée et une première sortie d'un module de ligne (ZM1") à une borne de grille de tous les premiers des deux transistors de sélection (PTR7...) montés en série, destinés à entrer des informations de la ligne de cellules de mémoire associée, en ce qu'une première entrée de chaque module de ligne (ZM1"...ZM4") doit être câblée avec la ligne de colonne d'écriture (SS'), une deuxième entrée de chaque module de ligne (ZM1"...ZM4") avec la ligne de colonne de lecture (SL') et une troisième entrée d'un module de ligne (ZM1") avec le circuit d'adresse de ligne (Z1,1') associé, en ce qu'un circuit de colonne comporte m grilles de sélection (AG1"...AG4"), respectivement une grille de sélection étant attribuée à une colonne de cellules de mémoire, et une sortie d'une grille de sélection (AG4") est reliée à une borne de grille de tous les deuxièmes des deux transistors de sélection (PTR8...) montés en série, destinés à entrer des informations de la ligne de cellules de mémoire associée et à une deuxième entrée des deux entrées par colonne du circuit d'exploitation de données (DAS), en ce qu'une première entrée d'une grille de sélection est câblée avec le circuit de ligne (Z2') et une deuxième entrée d'une grille de sélection (AG1") avec la ligne d'adresse de colonne (S1,1') associée à la grille de sélection.

14. Mémoire composée hiérarchiquement de cellules de mémoire selon la revendication 13, caractérisée en ce que chaque module de ligne (ZM1"...ZM4") comporte deux grilles NON-OU (NOR9, NOR10...NOR14, NOR15), et une sortie de la première grille NON-OU (NOR9...) forme la première sortie, une sortie de la deuxième grille NON-OU (NOR10...) la deuxième sortie de respectivement un module de ligne (ZM1"), une première entrée de la première grille NON-OU (NOR9) constitue la première entrée d'un module de ligne (ZM1"), une première entrée de la deuxième grille NON-OU (NOR10) la deuxième entrée d'un module de ligne (ZM1") et une deuxième entrée de la première grille NON-OU (NOR9) comporte ensemble avec une deuxième entrée de la deuxième grille NON-OU (NOR10) la troisième entrée d'un module de ligne (ZM1"), en ce que chaque grille de sélection (AG1"...AG4") comporte une grille NON-OU, une sortie d'une grille NON-OU formant la sortie d'une grille de sélection (AG1"...AG4") et une première et une deuxième entrée de la grille NON-OU respectivement la première et la deuxième entrée d'une grille de sélection (AG1"...AG4") et en ce que des signaux "active low" sont appliqués aux circuits d'adresse de ligne (Z1,1'...Z1,4'), aux circuits d'adresse de colonne (S1,1'...S1,4'), à la ligne de colonne de lecture (SL'), à la ligne de colonne d'écriture (SS'), au circuit de ligne (Z2') et à la ligne d'entrée de données (DE').

15. Mémoire composée hiérarchiquement de cellules de mémoire selon la revendication 8, caractérisée en ce qu'une ligne de colonne (S2'), un circuit de ligne de lecture (ZL'), un circuit de ligne d'écriture (ZS'), une ligne d'entrée de données (DE') et une ligne de sortie de données (DA') sont attribués au groupe de mémoire, en ce que le circuit de ligne (ZSl) comporte n modules de ligne (ZM1‴...ZM4‴), respectivement un module de ligne étant attribué à une ligne de cellules de mémoire, en ce qu'une sortie de chaque module de ligne (ZM1‴) est reliée à une borne de grille de chaque premier des transistors de sélection (PTR7...) destinés à entrer des informations de la ligne de cellules de mémoire associée et à une borne de grille de chaque transistor de sélection (ATR2...) destiné à sortir des informations de la ligne de cellules de mémoire associée, en ce qu'une première entrée de chaque module de ligne (ZM1‴) doit être reliée à la ligne de colonne (S2') et une deuxième entrée de chaque module de ligne (ZM1‴) au circuit d'adresse de ligne (Z1,1') associé, en ce qu'un circuit de colonne (SPS"') comporte m grilles de sélection (AG1‴...AG4‴), respectivement une grille de sélection étant attribuée à une colonne de cellules de mémoire, en ce qu'une première sortie d'une grille de sélection (AG4‴) est reliée à une borne de grille de chaque deuxième des deux transistors de sélection (PTR8...) montés en série, destinés à entrer des informations de la ligne de cellules de mémoire associée et une deuxième sortie d'une grille de sélection à une deuxième entrée des deux entrées par colonne du circuit d'exploitation de données (DAS), en ce qu'une première entrée d'une grille de sélection (AG1‴) est câblée avec le circuit de ligne d'écriture (ZS'), une deuxième entrée d'une grille de sélection avec le circuit de ligne de lecture (ZL') et une troisième entrée avec le circuit d'adresse de colonne (S1,1') associée.

16. Mémoire composée hiérarchiquement de cellules de mémoire selon la revendication 15, caractérisée en ce que chaque module de ligne (ZM1‴ à ZM4‴) comporte une grille NON-OU et une sortie de la grille NON-OU forme la sortie d'un module de ligne (ZM1‴...ZM4‴) et une première et une deuxième entrée d'une grille NON-OU forment la première et la deuxième entrée d'un module de ligne (ZM1‴...ZM4‴), en ce que chaque grille de sélection (AG1‴...AG4‴) comporte deux grilles NON-OU, une sortie de la première grille NON-OU (NOR16) formant la première sortie d'une grille de sélection (AG1‴) et une sortie de la deuxième grille NON-OU (NOR17) la deuxième sortie d'une grille de sélection (AG1‴), en ce qu'une première entrée d'une première grille NON-OU (NOR16) constitue la première entrée d'une grille de sélection (AG1‴), une première entrée de la deuxième grille NON-OU (NOR17) la deuxième entrée d'une grille de sélection (AG1‴), et une deuxième entrée de la première grille NON-OU (NOR16) et une deuxième entrée de la deuxième grille NON-OU (NOR17) sont câblées ensemble avec la troisième entrée d'une grille de sélection (AG1‴), et des signaux "active low" sont appliqués aux circuits d'adresse de ligne (Z1,1'...Z1,4'), aux circuits d'adresse de colonne (S1,1'...S1,4'), à la ligne de colonne (S2'), au circuit de ligne de lecture (ZL'), au circuit de ligne d'écriture (ZS') et à la ligne d'entrée de données (DE').
